# EUROPEAN PATENT APPLICATION

(11) **EP 4 654 766 A1**
(43) Date of publication of application: **26.11.2025**
(21) Application number: 24178072.5
(22) Date of filing: 24.05.2024
(51) Int. Cl.: H05K 7/20

(54) **COOLING FLUID DEFLECTOR**

(71) Applicant: RNV Holding B.V., 5684 ZT Best (NL)
(72) Inventor: HAJAGOS, Bence, 5656 AE Eindhoven (NL); VERWEIJ, Rudie Nolasco, 5656 AE Eindhoven (NL); KEMP, Arthur Anton Jacob, 5656 AE Eindhoven (NL)
(74) Representative: EP&C

(57) **Abstract**

A cooling fluid deflector (100) is provided. The cooling fluid deflector may be used in a server (102) that includes a first processor (104) and a second processor (106) wherein the first and second processors are arranged on a plane, and sequentially with respect to a server cooling fluid inflow direction (110). The cooling fluid deflector (100) is configured to be disposed between the first processor (104) and the second processor (106). The cooling fluid deflector (100) re-directs a first portion (112) of a cooling fluid inflow (114) that has entered the server (102) along the server cooling fluid inflow direction (110) and has cooled the first processor (104) such that at least a portion of the re-directed first portion of the cooling fluid inflow bypasses the second processor (106) by passing laterally with respect to the second processor. The cooling fluid deflector (100) also re-directs a second portion (116) of the cooling fluid inflow (114) that has bypassed the first processor (104) such that at least a portion of the re-directed second portion of the cooling fluid inflow flowing laterally across the plane (108) cools the second processor (106).

## Description

### Technical Field

The present disclosure relates to the cooling of processors. More particularly, it relates to the cooling of processors that are used in servers. A cooling fluid deflector, a kit of cooling fluid deflectors, a baffle that includes the cooling fluid deflector, a cover that includes the cooling fluid deflector, and a server that includes the cooling fluid deflector, are disclosed.

### Background

Servers typically include multiple processors that are used to process data. A server may also include other devices, such as memory, input-output devices, and so forth.

During their operation, servers generate significant amounts of heat. A key source of the heat is the processors that are in the server. Removing this heat from the server is important in maintaining the temperature of the processors below a level at which it significantly impacts their processing performance. The heat is typically removed by a cooling system that employs a cooling fluid, i.e. a gas, or a liquid. A fluid-moving device such as a fan, a piezoelectric cooler, a pump, a loudspeaker, or an ionic thruster, may be used to cause the cooling fluid to come into thermal contact with the processors, e.g. via a heatsink, thereby removing the heat.

However, there remain challenges to removing the heat from processors such as those used in servers. These challenges are often addressed simply by increasing the cooling capacity of the cooling system that is used to cool the server. However, this solution has drawbacks. For instance, it typically provides only a modest improvement in the processing performance of the server at the expense of a significant increase in its overall power consumption. Consequently, there is a need for solutions that improve the cooling of processors that are used in servers.

### Summary

According to one aspect of the present disclosure, a cooling fluid deflector is provided. The cooling fluid deflector may be used in a server that includes a first processor and a second processor wherein the first and second processors are arranged on a plane defined by a support layer of the first processor and/or the second processor and sequentially with respect to a server cooling fluid inflow direction. At least a portion of the cooling fluid deflector is configured to be disposed between the first processor and the second processor. The cooling fluid deflector is configured to re-direct a first portion of a cooling fluid inflow that has entered the server along the cooling fluid inflow direction and has cooled the first processor, laterally with respect to the server cooling fluid inflow direction and across the plane such that at least a portion of the re-directed first portion of the cooling fluid inflow bypasses the second processor by passing laterally with respect to the second processor. The cooling fluid deflector is also configured to re-direct a second portion of the cooling fluid inflow that has bypassed the first processor, laterally with respect to the server cooling fluid inflow direction and across the plane such that at least a portion of the re-directed second portion of the cooling fluid inflow flowing laterally across the plane cools the second processor.

The inventors have determined that a drawback of existing cooling solutions for servers in which the processors are arranged sequentially with respect to a server cooling fluid inflow direction, is that the cooling of an upstream processor often impacts the cooling of a downstream processor. This is known as thermal shadowing. In such arrangements, the known approach of simply increasing the cooling capacity of the cooling system that is used to cool the server may benefit the upstream processor whilst providing only a modest benefit to the downstream processor. Typically, the known approach results in the processing performance of the downstream processor limiting the overall performance of the server.

In the above-described cooling fluid deflector, at least a portion of the re-directed first portion of the cooling fluid inflow that has cooled the first processor, bypasses the second processor. Also, at least a portion of the re-directed second portion of the cooling fluid inflow that has bypassed the first processor, cools the second processor. The former feature reduces the impact of heat generated by the first processor on the second processor, or in other words, it improves the cooling of the second processor. In other words, it reduces the thermal shadowing of the second processor by the first processor. The latter feature likewise improves the cooling of the second processor because the second processor is cooled using the re-directed second portion of the cooling fluid inflow that has bypassed the first processor. Thus, together, these features improve the processing performance of the second processor, which in-turn has the synergistic effect of improving the overall processing performance of the server.

Further aspects, features, and advantages of the present disclosure will become apparent from the following description of examples, which is made with reference to the accompanying drawings.

### Brief Description of the Drawings

Fig. 1 is a schematic diagram illustrating a first example of a cooling fluid deflector 100 for use in a server 102, in accordance with some aspects of the disclosure.
Fig. 2 is a schematic diagram illustrating a second example of a cooling fluid deflector 100 for use in a server 102, in accordance with some aspects of the disclosure.
Fig. 3 is a schematic diagram illustrating a third example of a cooling fluid deflector 100 for use in a server 102, in accordance with some aspects of the disclosure.
Fig. 4 is a schematic diagram illustrating a fourth example of a cooling fluid deflector 100 for use in a server 102, in accordance with some aspects of the disclosure.
Fig. 5 is a schematic diagram illustrating a fifth example of a cooling fluid deflector 100 for use in a server 102, in accordance with some aspects of the disclosure.
Fig. 6 is a schematic diagram illustrating a sixth example of a cooling fluid deflector 100 for use in a server 102, in accordance with some aspects of the disclosure.
Fig. 7 is a schematic diagram illustrating a seventh example of a cooling fluid deflector 100 for use in a server 102, in accordance with some aspects of the disclosure.
Fig. 8 is a schematic diagram illustrating an eighth example of a cooling fluid deflector 100 for use in a server 102, in accordance with some aspects of the disclosure.
Fig. 9 is a schematic diagram illustrating a ninth example of a cooling fluid deflector 100 for use in a server 102, in accordance with some aspects of the disclosure.
Fig. 10 is a schematic diagram illustrating a perspective view of an example of a cooling fluid deflector 100 for use in a server, in accordance with some aspects of the disclosure.
Fig. 11 is a schematic diagram illustrating a tenth example of a cooling fluid deflector 100 for use in a server, in accordance with some aspects of the disclosure.
Fig. 12 is a schematic diagram illustrating an eleventh example of a cooling fluid deflector 100 for use in a server, in accordance with some aspects of the disclosure.
Fig. 13 is a schematic diagram illustrating a twelfth example of a cooling fluid deflector 100 for use in a server, in accordance with some aspects of the disclosure.
Fig. 14 is a schematic diagram illustrating a thirteenth example of a cooling fluid deflector 100 for use in a server, in accordance with some aspects of the disclosure.
Fig. 15 is a schematic diagram illustrating an example of a cooling fluid deflector 200 for use in a server 102 and wherein the cooling fluid deflector is provided by a fluid-moving device, in accordance with some aspects of the disclosure.
Fig. 16 is a schematic diagram illustrating an example of a cooling fluid deflector 300 for use in a server and wherein the cooling fluid deflector 300 is provided by a heatsink 126, in accordance with some aspects of the disclosure.
Fig. 17 is a schematic diagram illustrating an example of a cooling fluid deflector 300 for use in a server 102 and wherein the cooling fluid deflector 300 is provided by a heatsink 136 of a first processor 104, in accordance with some aspects of the disclosure.
Fig. 18 is a schematic diagram illustrating an example of a cooling fluid deflector 300 for use in a server 102 and wherein the cooling fluid deflector 300 is provided by a heatsink 138 of a second processor 106, in accordance with some aspects of the disclosure.
Fig. 19 is a schematic diagram illustrating an example of a cooling fluid deflector 300 for use in a server 102 and wherein the cooling fluid deflector 300 is provided by the heatsinks 136', 138' of both a first processor 104 and a second processor 106, in accordance with some aspects of the disclosure.
Fig. 20 is a schematic diagram illustrating an example of a cooling fluid deflector 300 for use in a server 102 and wherein the cooling fluid deflector 300 is provided by a common heatsink 140 of the first and second processors 104, 106, in accordance with some aspects of the disclosure.
Fig. 21 is a schematic diagram illustrating a first example of a cooling fluid deflector 100, a second cooling fluid deflector 400, and a third cooling fluid deflector 500 for use in a server 102, in accordance with some aspects of the disclosure.
Fig. 22 is a schematic diagram illustrating a second example of a cooling fluid deflector 100, a second cooling fluid deflector 400, and a third cooling fluid deflector 500 for use in a server 102, in accordance with some aspects of the disclosure.
Fig. 23 is a schematic diagram illustrating a third example of a cooling fluid deflector 100, a second cooling fluid deflector 400, and a third cooling fluid deflector 500 for use in a server 102, in accordance with some aspects of the disclosure.
Fig. 24 is a schematic diagram illustrating an example of a cover 142 for a server wherein the cover includes a cooling fluid deflector 100, a second cooling fluid deflector 400, and a third cooling fluid deflector 500, in accordance with some aspects of the disclosure.

### Detailed Description

Examples of the present disclosure are provided with reference to the following description and figures. In this description, for the purposes of explanation, numerous specific details of certain examples are set forth. Reference in the specification to "an example", "an implementation" or similar language means that a feature, structure, or characteristic described in connection with the example is included in at least that one example. It is also to be appreciated that features described in relation to one example may also be used in another example, and that all features are not necessarily duplicated in each example for the sake of brevity. For instance, features described in relation to one cooling fluid deflect may be implemented in another cooling fluid deflector in a corresponding manner. It is also to be appreciated that features described in relation to a cooling fluid deflector, may be implemented in a kit, or a baffle, or a cover, or a server, that includes a cooling fluid deflector, in a corresponding manner.

In the following description, reference is made to examples of cooling fluid deflectors that may be used in a server. It is to be appreciated that the cooling fluid deflectors described herein may be used in various types of servers, including, and without limitation, a blade server, a small form factor server, a conventional server, (19") rack-mount server, Open Compute Project "OCP" platform server, and so forth. Aside from their use in servers, the cooling fluid deflectors disclosed herein may alternatively be used in other types of processing systems, including in computing systems such as desktop processors, laptops, computing units in vehicles, satellites, defence platforms, and so forth.

Reference is also made herein to examples of cooling fluid deflectors that may be used in servers that include processors. It is to be appreciated that the term processor is not intended to refer to a specific type of processor, and that the cooling fluid deflectors described herein may be used in servers that include various types of processors, including, and without limitation, Central Processing Units "CPUs", Digital Signal Processors "DSPs", Graphics Processing Units "GPUs", Neural Processing Units "NPUs", AI accelerators, deep learning processors, Tensor Processing Units "TPUs", Field-Programmable Gate Arrays "FPGAs", Application-Specific Integrated Circuits "ASICs", Photonic Integrated Circuits "PICs", Analog Signal Processor "ASPs", Mixed-signal Integrated Circuits "MICs", and so forth.

As mentioned above, there is a need for solutions that improve the cooling of processors that are used in servers.

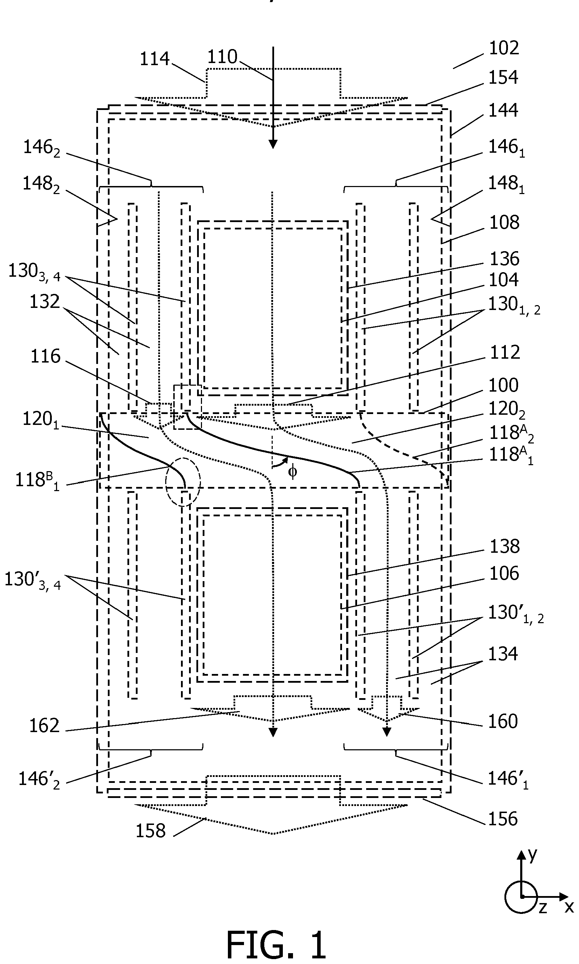

Fig. 1 is a schematic diagram illustrating a first example of a cooling fluid deflector 100 for use in a server 102, in accordance with some aspects of the disclosure. In order to elucidate the operation of the cooling fluid deflector, an initial description is provided of the servers in which the cooling fluid deflector may be used.

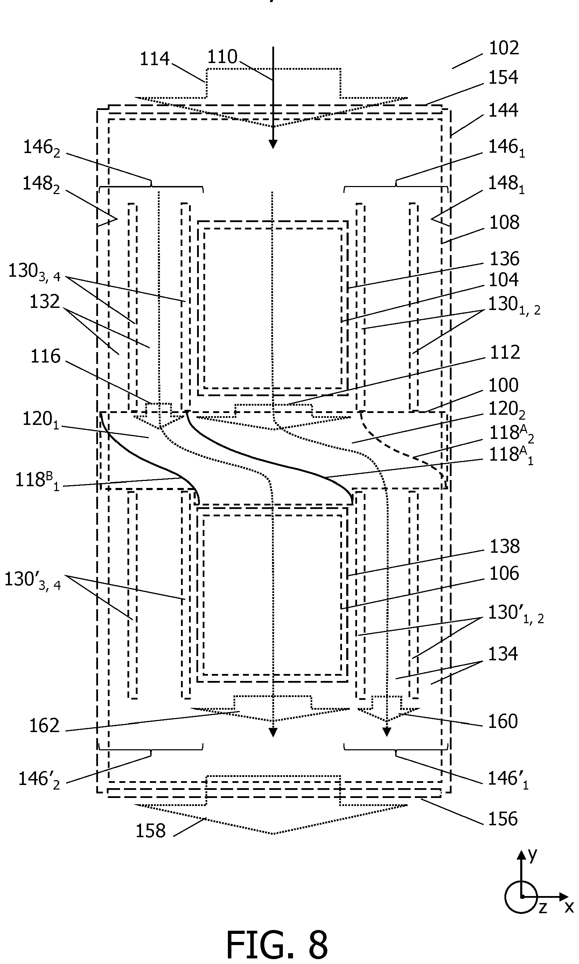

In general, the cooling fluid deflector described herein may be used in a server that includes a first processor and a second processor. The first and second processors may be arranged on a plane defined by a support layer of the first processor and/or the second processor and sequentially with respect to a server cooling fluid inflow direction. The plane may be referred-to as a common plane since it is common to, i.e. shared by, both the first and second processors. Various examples of servers in which the cooling fluid deflector may be used are illustrated in Fig. 1 - 9, Fig. 15, and Fig. 17- 22. For instance, the server 102 illustrated in Fig. 1 includes a first processor 104 and a second processor 106. The first and second processors 104, 106, may be CPUs, or another type of processor, as described above. With continued reference to Fig. 1, the first and second processors 104, 106 are arranged on a plane 108 defined by a support layer of the first processor and/or the second processor.

In one example, the support layer is a motherboard that is common to, i.e. shared by, the first and second processors. In this example, the first and second processors are arranged on common plane 108 that is defined by the common motherboard, e.g. a surface of the common motherboard. In another example, the first and second processors 104, 106, are arranged on separate motherboards. In this example, the first and second processors 104, 106, are likewise arranged on common plane 108, in this example, the common plane is defined by the motherboard of the first processor 104, or by the motherboard of the second processor 106. It is noted that the cooling fluid deflector described herein may also be used in servers that include more than two processors and wherein at least two of the processors are arranged in this manner.

With continued reference to Fig. 1, the first and second processors 104 and 106, are arranged sequentially with respect to a server cooling fluid inflow direction 110. The server cooling fluid inflow direction 110 is the direction along which the cooling fluid enters the server 102. The server cooling fluid inflow direction 110 is indicated via the solid-line arrow at the top of Fig. 1. Thus, the first and second processors 104, 106, are arranged one after another as seen along the server cooling fluid inflow direction.

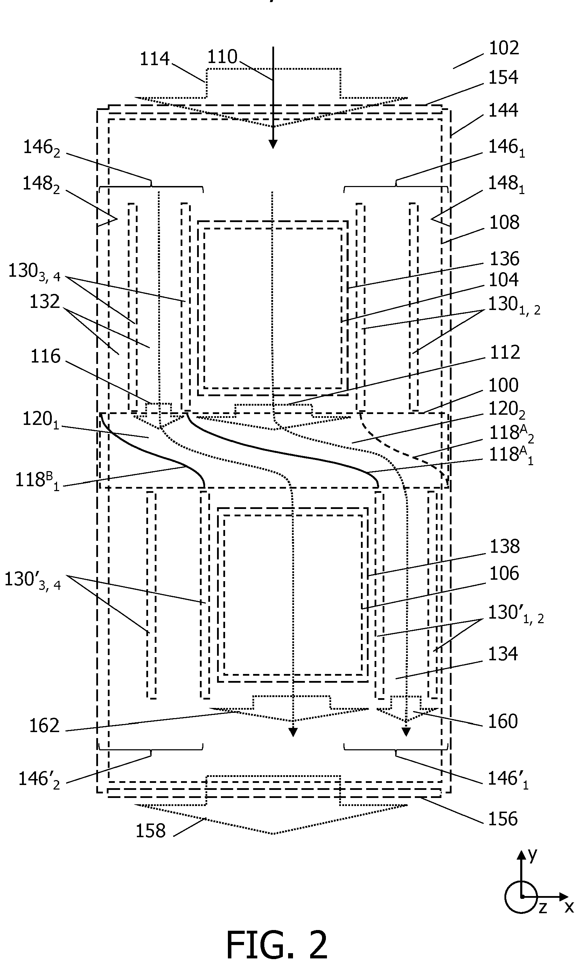

In the example illustrated in Fig. 1 the processors 104, 106 are arranged such that a virtual line that is parallel to the server cooling fluid inflow direction 110 passes through the centres of both of the processors 104, 106. The processors may be said to be arranged substantially symmetrically along the virtual line. This arrangement may be referred-to as an "in-line" processor arrangement. This arrangement results in an overlap between the profiles of the processors as seen along the server cooling fluid inflow direction 110. The cooling fluid deflectors 100 disclosed herein may be used in servers that include such an in-line processor arrangement. The cooling fluid deflectors 100 disclosed herein may also be used in servers that include different processor arrangements, such as in the servers 102 illustrated in Fig. 2 - Fig. 4. In these servers, the centre of one of the processors 104, 106 is offset laterally in a direction perpendicular to the server cooling fluid inflow direction such that a virtual line that is parallel to the server cooling fluid inflow direction 110 passes through the centre of only one of the two processors 104, 106. These arrangements may be referred-to as "staggered" processor arrangements. In the staggered processor arrangements illustrated in Fig. 2 - Fig. 4, there is also an overlap between the profiles of the processors as seen along the server cooling fluid inflow direction 110. The cooling fluid deflectors 100 disclosed herein may also be used in servers that include processor arrangements that are different to these examples. For instance, the cooling fluid deflectors 100 disclosed herein may be used in servers in which there is no overlap between the profiles of the processors as seen along the server cooling fluid inflow direction 110. Such arrangements may occur in "staggered" processor arrangements in which the centre of one of the processors 104, 106 is offset laterally, and by a significant amount, in a direction perpendicular to the server cooling fluid inflow direction.

It is also noted that whilst the first and second processors 104, 106 illustrated in the Figures have the same sizes, the cooling fluid deflector 100 disclosed herein may also be used in servers in which the processors have different sizes. For instance, the sizes of the footprints, or the profiles of the processors as seen along the server cooling fluid inflow direction 110, may be different. It is also noted if the first and second processors have profiles with different sizes and the processors have a staggered arrangement, this can also result in the absence of an overlap between the cross-sections of the processors as seen along the server cooling fluid inflow direction 110. It is also noted that that the cooling fluid deflectors disclosed herein may be used in servers in which the processors, and also other features within the servers, are mirrored versions of those illustrated in the Figures.

In some examples, the first and second processors 104, 106, are provided with one or more heatsinks. For instance, in the example illustrated in Fig. 1, the first processor may be provided with a heatsink 136, and the second processor may be provided with a heatsink 138. In an alternative configuration, the first and second processors may be provided with a common heatsink. Where present, the processors are thermally coupled to the corresponding heatsink(s). The heatsink(s) improve heat extraction from the processors.

In operation, a cooling fluid inflow 114, as indicated by the broad arrow at the top of e.g. Fig. 1, enters the server 102 along the server cooling fluid inflow direction 110. A temperature of the cooling fluid inflow 114 may be lower than a temperature of the first and second processors 104, 106 in order to cool the processors. As described in the examples below, portion(s) of the cooling fluid inflow 114 then pass over the first and second processors 104, 106, or through the heatsink(s) that are thermally coupled to the processor(s), in order to cool the processor(s). In general, the cooling fluid inflow 114 that enters the server 102 may be provided by any fluid, i.e. a liquid or a gas, that is suitable for cooling a server. Examples of fluids include two-phase/ multiphase fluids, and supercritical fluids. Examples of liquids include hydrocarbons such as mineral, synthetic, or biological oils, fluorinated liquids such as fluorocarbons, and also other liquids such as glycols, water. Examples of gases include nitrogen, carbon-dioxide, air, and its components. Examples of two-phase fluids include refrigerants, fire suppressants, such as Novec 7000, Novec 7100, Novec 7200, Fluorinert FC-72, R-134a, R1234yf, R-1336mzz(E), R-1336mzz(Z), R1233zd(E), R1224yd(Z), R-13I1, Opteon 2P50, Butane, Pentane. Examples of supercritical fluids include supercritical carbon dioxide, supercritical helium supercritical neon, supercritical nitrogen, supercritical water. A multiphase fluid may refer to a fluid where more than two phases of the same fluid is present. It may also refer to a fluid that consists of multiple phases of different fluids.

The liquid, or the gas, may include a mixture of liquids or gases respectively. For instance, the liquid may include a mixture of mineral, synthetic or biological oils, fluorinated liquids such as fluorocarbons. The liquid may alternatively include a mixture of water and an additive such as Propylene glycol, Ethylene glycol, and so forth, and the gas may include a mixture of air and carbon dioxide, or nitrogen, for example. Two phase fluid mixtures can include two or more refrigerants or fire suppressant agents, such as R-471A, R-476A, R-486A. Multiphase mixtures can include a two-phase liquid and oil, such as a refrigerant in two phase condition and oil, R134a and synthetic oil of polyolester, for example. A multiphase mixture can include a fluid at triple point, or other points, where three phases may occur at a given pressure or temperature, such as R134a or water. A multiphase mixture can include two fluid phases, such as gaseous/ liquid/ solid phases. The latter may include particles that are sized to travel with the fluid, such as nanoparticles, or Aluminium Oxide, Al₂O₃, for example.

In some examples, the first and second processors 104, 106 are provided with one or more memory boards. For instance, in the example illustrated in Fig. 1, the first and second processors 104, 106, may be provided with the memory boards 130_{1..4}, and 130'_{1..4}. The memory boards include one or more memory devices, such as Random Access Memory "RAM", e.g. Static/ Dynamic/ Phase-changing RAM and so forth, or another type of memory. The memory boards may also be referred to as memory Printed Circuit Boards "PCBs". Where present, the processors 104, 106, are in communication with the memory devices on the corresponding memory boards 130'_{1..4}, 130'_{1..4}. The processors store data to the memory devices on the corresponding memory boards. The data may be transferred to the memory devices via a communication bus. The memory boards 130'_{1..4}, 130'_{1..4}, may be coupled to the above-described motherboard(s) of the first and second processors 104, 106 via one or more connectors.

In some examples, the memory board(s) 130_{1..4}, 130'_{1..4} are arranged laterally with respect to the corresponding processor 104, 106 such that the one or more boards extend along the server cooling fluid inflow direction 110 and outwards with respect to the plane 108. The memory boards 130_{1..4}, 130'_{1..4}, may be arranged substantially normally with respect to the plane 108, for example. An example of this arrangement is illustrated in Fig. 1. This arrangement of the memory boards facilitates some of the cooling fluid inflow 114 to cool the memory devices that are coupled to the memory boards. In some examples, the memory boards serve a secondary purpose of guiding cooling fluid within the server. This likewise facilitates the cooling of the memory boards. In some examples, the memory board(s) may be separated from the corresponding processor to provide a memory board channel. The memory board channel is used to guide cooling fluid within the server. For instance, in the example illustrated in Fig. 1, the memory boards 130_{3, 4} of the first processor 104 are separated from the first processor 104 to provide a memory board channel 132 for guiding the second portion 116 of the cooling fluid inflow 114 past the first processor 104.

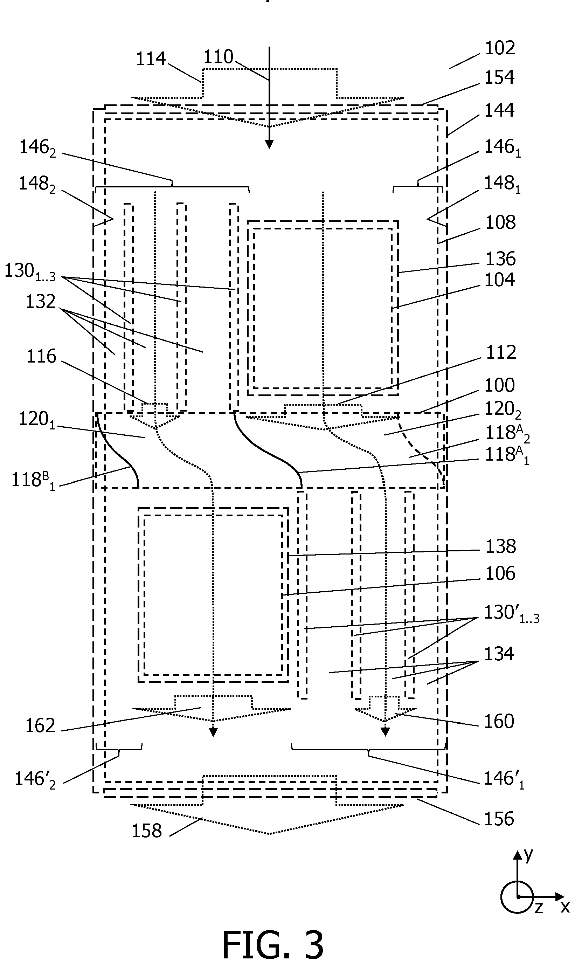

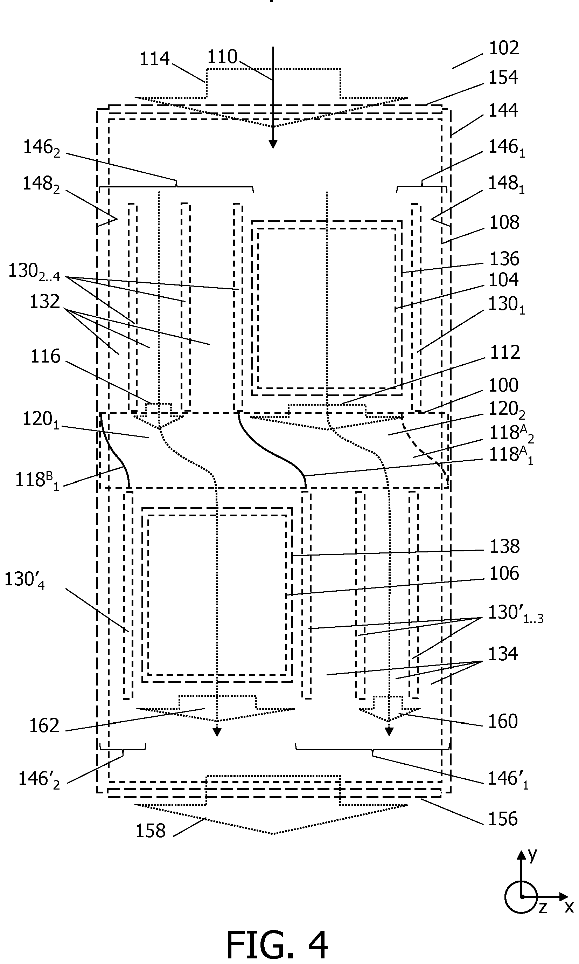

In some examples, the memory boards 130_{1..4} and 130'_{1..4} may be arranged symmetrically with respect to the first and second processors 104, 106, respectively. An example of this arrangement is illustrated in Fig. 1. In other examples, there may be a different arrangement, or a different number, of memory boards. Some examples of these alternative arrangements are illustrated in Fig. 3 and Fig. 4. For instance, in the server 102 illustrated in Fig. 3 the processors 104, 106 each include three memory boards, and these are arranged asymmetrically with all memory boards on one side of the corresponding processor. In the server 102 illustrated in Fig. 4, the processors 104, 106 each include four memory boards, and these are also arranged asymmetrically with respect to the corresponding processor.

It is noted that instead of providing the first and second processors with memory boards as described above, the first and second processors may be provided with one or more memory blanking boards. A memory blanking board has similar dimensions to a memory board and may be arranged in the same position as a memory board. A memory blanking board may also be coupled to the above-described motherboard(s) via the connector(s) described above. However, in contrast to a memory board, a memory blanking board does not include any memory devices. A memory blanking board may be included in a server in order to guide cooling fluid within the server in arrangements in which one or more of the memory boards described above are omitted.

In some examples, the server 102 is provided with a housing. For instance, in the example illustrated in Fig. 1, the server 102 may include the housing 144. The housing 144 may include a fluid inlet 154 and a fluid outlet 156 to facilitate the cooling fluid inflow 114 and the fluid outflow to 158 to respectively enter and exit the server housing 144. The fluid outflow 158 exiting the server 102 includes the portion 160 of the cooling fluid inflow that has bypassed the second processor, and also the portion 162 of the cooling fluid inflow that has passed through the second processor. The housing 144 may be formed from a material such as a metal, or a polymer.

In some examples, the processors may be arranged within the housing to provide a gap between the processor and each of two opposing inner surfaces of the housing. For instance, in the example illustrated in Fig. 1, the processors 104, 106 may be arranged within the housing to provide a gap 146_{1,2}, 146'_{1,2} between each processor and each of two opposing inner surfaces 148₁, 148₂ of the housing 144. The gaps are disposed laterally with respect to the corresponding processor 104, 106. In some examples, the gaps facilitate the flow of cooling fluid within the housing, e.g. to cool memory devices coupled to the memory board(s).

In some examples, the server 102 is provided with at least one fluid-moving device. The at least one fluid-moving device is configured to provide the cooling fluid inflow 114 in the server cooling fluid inflow direction 110. In general, the fluid-moving device may be disposed at the fluid inlet 154 and/or at the fluid outlet 156 and/or at a position between the fluid inlet 154 and the fluid outlet 156. For instance, in the example illustrated in Fig. 1, the server 102 may be provided with a fluid-moving device (not illustrated in Fig. 1) that is coupled to the fluid inlet 154, or to the fluid outlet 156. Various types of fluid-moving devices may be used, such as a fan, a piezoelectric cooler, a pump, a loudspeaker, or an ionic thruster, and so forth. In other examples, a fluid-moving device is not provided, the cooling fluid inflow 114 instead being provided by thermal convection.

Turning now to the cooling fluid deflector. In general, it is noted that the cooling fluid deflectors disclosed herein may be used in servers that include one or more of the features of the servers described above. Thus, whilst many of these features are shown in the Figures, they may be optional in some implementations, as indicated via their dashed outlines.

In one set of examples, a cooling fluid deflector 100, 200 300, is provided wherein at least a portion of the cooling fluid deflector 100, 200, 300 is configured to be disposed between the first processor 104 and the second processor 106. The cooling fluid deflector 100, 200, 300 is configured to re-direct a first portion 112 of a cooling fluid inflow 114 that has entered the server 102 along the server cooling fluid inflow direction 110 and has cooled the first processor 104, laterally with respect to the server cooling fluid inflow direction and across the plane 108 such that at least a portion of the re-directed first portion of the cooling fluid inflow bypasses the second processor 106 by passing laterally with respect to the second processor. The cooling fluid deflector 100, 200, 300 is configured to re-direct a second portion 116 of the cooling fluid inflow 114 that has bypassed the first processor 104, laterally with respect to the server cooling fluid inflow direction 110 and across the plane 108 such that at least a portion of the re-directed second portion of the cooling fluid inflow flowing laterally across the plane 108 cools the second processor 106.

In the above-described cooling fluid deflector, at least a portion of the re-directed first portion of the cooling fluid inflow that has cooled the first processor, bypasses the second processor. Also, at least a portion of the re-directed second portion of the cooling fluid inflow that has bypassed the first processor, cools the second processor. The former feature reduces the impact of heat generated by the first processor on the second processor, or in other words, it improves the cooling of the second processor. In other words, it reduces the thermal shadowing of the second processor by the first processor. The latter feature likewise improves the cooling of the second processor because the second processor is cooled using the re-directed second portion of the cooling fluid inflow that has bypassed the first processor. Thus, together, these features improve the processing performance of the second processor, which in-turn has the synergistic effect of improving the overall processing performance of the server.

Examples of cooling fluid deflectors 100, 200, 300 in accordance with this set of examples are illustrated throughout Fig. 1 - Fig. 24. For instance, in Fig. 1, at least a portion of the cooling fluid deflector 100 is configured to be disposed between the first processor 104 and the second processor 106 in the server 102. Moreover, as may be seen from the first and second portions 112, and 116, of the cooling fluid inflow 114 illustrated throughout Fig. 1 - Fig. 24, and also by their associated dotted lines, the cooling fluid deflector 100, 200, 300 is configured to re-direct a first portion 112 of a cooling fluid inflow 114 that has entered the server 102 along the server cooling fluid inflow direction 110 and has cooled the first processor 104, laterally with respect to the server cooling fluid inflow direction and across the plane 108 such that at least a portion of the re-directed first portion of the cooling fluid inflow bypasses the second processor 106 by passing laterally with respect to the second processor. This reduces the amount of heat that may be transferred to the second processor 106. This function of the cooling fluid deflector 100 is indicated via the dotted line in the central region of Fig. 1, and which indicates the re-direction of the first portion 112 of a cooling fluid inflow 114 in the positive x direction. The re-directed first portion 112 of the cooling fluid inflow 114 that has cooled the first processor 104 (labelled as the fluid flow 160 in Fig. 1) may subsequently leave the server via the fluid outlet 156. As illustrated throughout Fig. 1 - Fig. 24, the first portion 112 of the cooling fluid inflow 114 may be re-directed in a direction that is substantially parallel to the plane 108. This has the benefit of improving the flow of the cooling fluid. The first portion 112 of the cooling fluid inflow 114 that has entered the server 102 along the server cooling fluid inflow direction 110 and has cooled the first processor 104, may be re-directed laterally with respect to the server cooling fluid inflow direction and across the plane 108 such that at least a portion of the re-directed first portion of the cooling fluid inflow bypasses the second processor 106 by passing laterally with respect to the second processor without being re-directed in an out-of-plane direction with respect to the plane 108. This has the benefit of further improving the flow of the cooling fluid. As illustrated throughout Fig. 1 - Fig. 24, in examples in which the second processor is thermally coupled to a heatsink 138, the re-directed first portion of the cooling fluid inflow may bypass the second processor 106 by passing laterally with respect to the heatsink of the second processor 106.

The cooling fluid deflector 100 illustrated in Fig. 1 - Fig. 24 is also configured to re-direct a second portion 116 of the cooling fluid inflow 114 that has bypassed the first processor 104, laterally with respect to the server cooling fluid inflow direction 110 and across the plane 108 such that at least a portion of the re-directed second portion of the cooling fluid inflow flowing laterally across the plane 108 cools the second processor 106. Bypassing the first processor reduces the amount of heat that may be transferred from the first processor 104 to the second portion 116 of the cooling fluid inflow 114. This function of the cooling fluid deflector 100 is indicated via the dotted line on the left-hand side of Fig. 1, and which indicates the re-direction of the second portion 116 of the cooling fluid inflow 114 in the positive x direction. The at least a portion of the re-directed second portion of the cooling fluid inflow that has cooled the second processor 106 (labelled as the fluid flow 162 in Fig. 1) may subsequently leave the server via the fluid outlet 156. As illustrated throughout Fig. 1 - Fig. 24, the second portion 116 of the cooling fluid inflow 114 may be re-directed in a direction that is substantially parallel to the plane 108. This has the benefit of improving the flow of the cooling fluid. As illustrated throughout Fig. 1 - Fig. 24, the second portion 116 of the cooling fluid inflow 114 that has bypassed the first processor 104, may be re-directed laterally with respect to the server cooling fluid inflow direction 110 and across the plane 108 such that the least a portion of the re-directed second portion of the cooling fluid inflow flowing laterally across the plane 108 cools the second processor 106 without being re-directed in an out-of-plane direction with respect to the plane 108. This has the benefit of further improving the flow of the cooling fluid. As illustrated throughout Fig. 1 - Fig. 24, the second portion 116 of the cooling fluid inflow 114 may bypass the first processor 104 by passing laterally with respect to the first processor 104. Bypassing the first processor 104 in this manner reduces the amount of heat that may be transferred to the second portion 116 of the cooling fluid inflow 114 by the first processor 104. As illustrated throughout Fig. 1 - Fig. 24, in examples in which the first processor is thermally coupled to a heatsink 136, the second portion 116 of the cooling fluid inflow 114 may bypass the first processor 104 by passing laterally with respect to the heatsink of the first processor 104. This further reduces the amount of heat that may be transferred to the second portion 116 of the cooling fluid inflow 114 by the heatsink of the first processor 104.

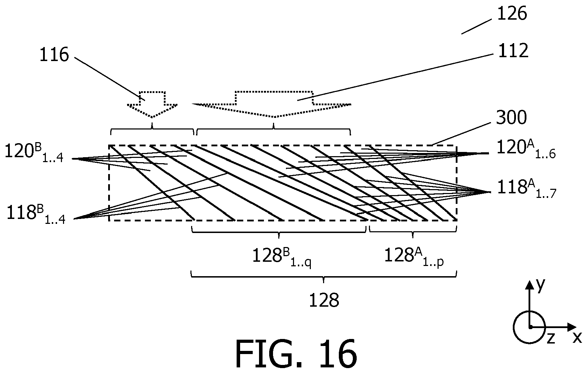

In the examples illustrated in Fig. 1 - Fig. 14, and in Fig. 16 - Fig. 24, the aforementioned re-directing functions are performed by a plurality of foils 118. In these examples, the cooling fluid deflector 100 comprises a plurality of foils 118, including at least a first foil 118^{A}_{1..i}, and at least a second foil 118^{B}_{1..j}. The at least a first foil 118^{A}_{1..i} is configured to cause the re-directing of the first portion 112 of the cooling fluid inflow 114 that has cooled the first processor 104, laterally with respect to the server cooling fluid inflow direction and across the plane 108. The at least a second foil 118^{B}_{1..j} is configured to cause the re-directing of the second portion 116 of the cooling fluid inflow 114 that has bypassed the first processor 104, laterally with respect to the server cooling fluid inflow direction 110 and across the plane 108. In examples in which foils are used, the foils may be considered to deflect the first portion 112 of a cooling fluid inflow 114 that has entered the server 102, and to deflect the second portion 116 of the cooling fluid inflow 114 that has bypassed the first processor 104. The foils 118 may extend substantially the entire distance between the plane 108 and an inner surface of a cover of the server 102.

In the example illustrated in Fig. 1, there may be two foils, i.e. the first foil 118^{A}₁ and the second foil 118^{B}₁. In other examples, there may be more than two foils. For instance, the example illustrated in Fig. 1 may also include the optional foil 118^{A}₂. The foil 118^{A}₂ improves the guiding of the fluid flow, in this example by smoothing the flow of the first portion 112 of the cooling fluid inflow 114 that has cooled the first processor 104, as it bypasses the second processor 106.

In some examples, the cooling fluid deflector may be configured to cause the re-directing of the first and second portions 112, 116 of the cooling fluid inflow laterally in a same direction. This provides efficient routing of the cooling fluid within the server. In the example illustrated in Fig. 1, the first and second portions 112, 116 of the cooling fluid inflow are re-directed laterally in a transverse direction with respect to the y axis that is labelled in the lower portion of Fig. 1.

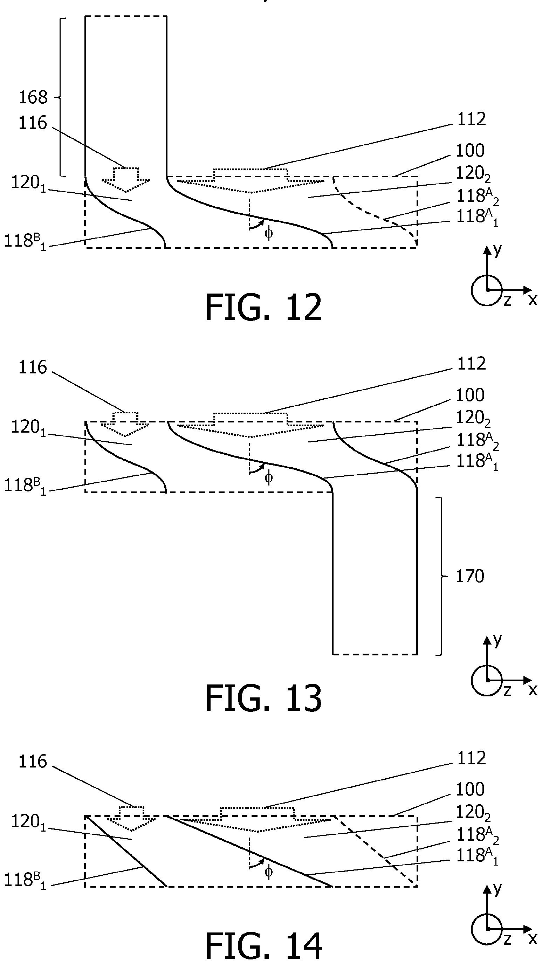

In some examples in which foils are used, a portion of a foil may extend beyond the region between the first and second processor(s). For instance, in the example illustrated in Fig. 12, the first foil 118^{A}₁ and the second foil 118^{B}₁ define a first guide channel 168 that extends alongside the first processor 104 for guiding the second portion 116 of the cooling fluid inflow 114 past the first processor 104. Similarly, in the example illustrated in Fig. 13, the first foils 118^{A}₁ and 118^{A}₂ define a second guide channel 168 that extends alongside the second processor 106 for guiding the at least a portion of the re-directed first portion of the cooling fluid inflow past the second processor 106.

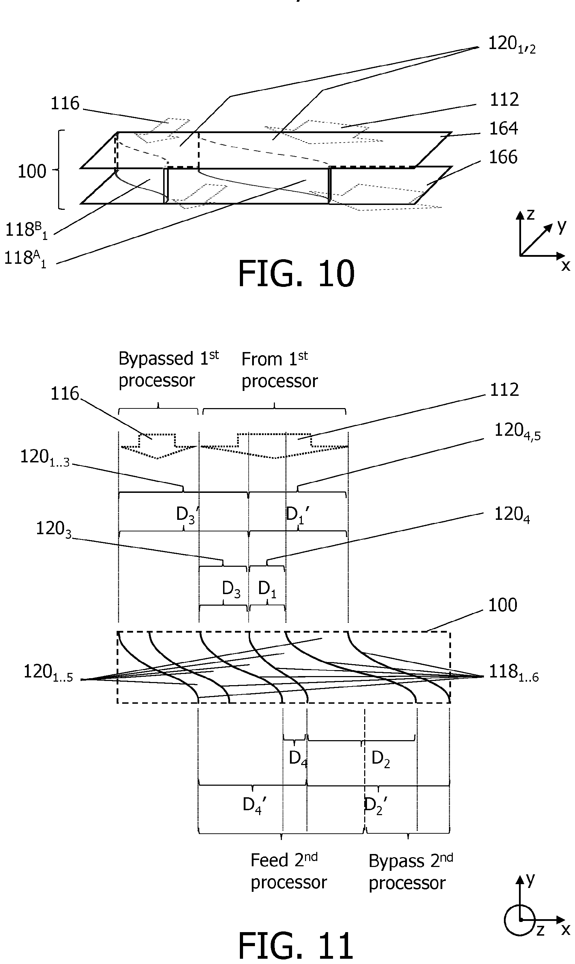

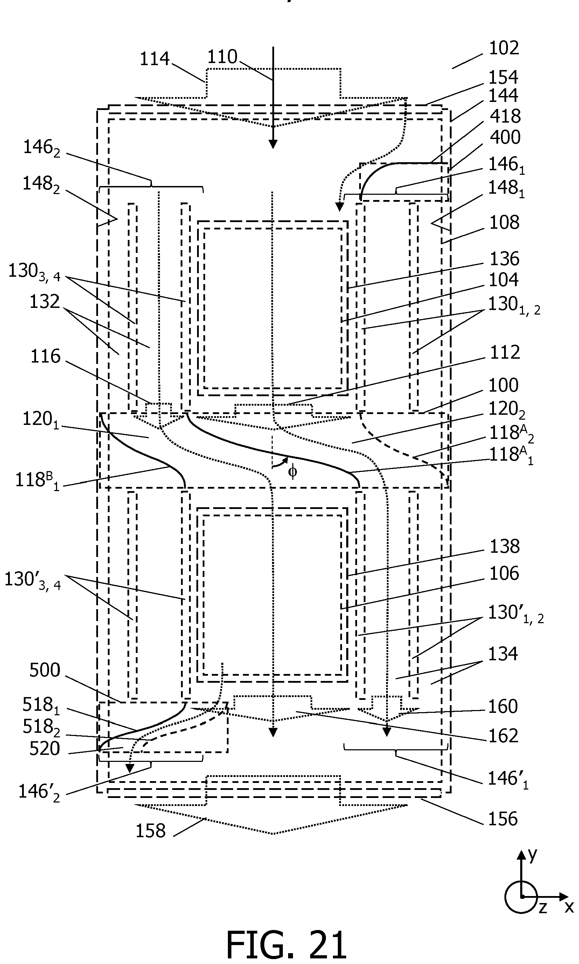

In general, the foils 118 may have various profiles. For instance, in the example illustrated in Fig. 1 - Fig. 13, and in Fig. 21 - Fig. 24, the foils 118 have curved profiles. In the example illustrated in Fig. 14 and in Fig. 16 - Fig. 20 the foils have straight profiles. The use of a curved profile may provide a smoother flow of the cooling fluid through the cooling fluid deflector. The foils illustrated in the Figures are also illustrated as being continuous structures. In some examples, the foils may instead be provided by multiple discrete foil segments that together function as a foil. The length, spacing, and orientation of the foil segments may be defined so as to provide the function of the foil. In some examples, the foils may be provided with a support. For instance, in the example illustrated in Fig. 10, the first and second foils 118^{A}₁, and 118^{A}₂, include an upper support 164 and/or a lower support 166. The support(s) mechanically couple the foils together. The support(s) facilitate the (retro)fitting of the cooling fluid deflector into the server 102. The outlines of the supports 164, 166, of the cooling fluid deflectors are illustrated throughout the Figures, e.g. the cooling fluid deflector 100 in Fig. 1. The foils described above may be formed from various materials, including various metals, alloys, polymers, ceramics, composite materials, and so forth. For instance, the foils 118 may be formed from a metal such as aluminium, or a polymer such as polycarbonate, or acrylonitrile butadiene styrene "ABS", or Acetal, or Acrylic, or Nylon, or polypropylene, and so forth. Examples of suitable ceramics include silicon carbide, boron nitride, and so forth. Examples of composite materials include carbon fibre reinforced plastic, and so forth.

In some examples, the at least a first foil 118^{A}₁ and/or the at least a second foil 118^{B}₁ are arranged at an acute angle, ϕ, with respect to the server cooling fluid inflow direction 110. For instance, the first foil 118^{A}₁ illustrated in Fig. 1 is arranged at an acute angle, ϕ, to the server cooling fluid inflow direction 110. This arrangement improves the flow of the cooling fluid through the cooling fluid deflector 100.

In some examples, the at least a first foil 118^{A}₁ and/or the at least a second foil 118^{B}₁ are adjustable for adjusting an angle, ϕ, of the respective foil with respect to the server cooling fluid inflow direction 110. In this example, the foil(s) may be adjustable via a threaded screw, a hinge, or another mechanism, or alternatively the foil(s) may be formed from a bendable material such as a metal.

In one example, the server 102 includes a cover 142, and a maximum dimension of the cooling fluid deflector in a normal direction, z, with respect to the plane 108 is less than or equal to a separation between the plane and an inner surface of the cover 142. This enables the cooling fluid deflector to be (retro)fitted into the server 102.

In one example, the foils define channels, and the relative sizes of the inlet and outlet cross sectional areas of the channels are defined so as to improve the cooling of the first processor 104. The inventors have observed that the cooling of a processor may be improved by feeding cooling fluid to the processor, or by extracting cooling fluid from the processor, using a channel that is coupled to a given fluid flow wherein the ends of the channel have differently-sized cross sectional areas. When such a channel is coupled to a fluid flow such that the end of the channel with the relatively smaller cross sectional area faces the processor, the fluid flow at this end of the channel is increased as compared to the given fluid flow at the end of the channel with the relatively smaller cross sectional area. The increase in fluid flow improves the cooling of the processor as compared to using the given fluid flow to cool the processor.

In this example, the cooling fluid deflector 100 comprises a plurality of foils 118. The foils define one or more channels 120, including: a first set of one or more channels 120₄, 120_{4,5} configured to feed a portion of the first portion 112 of the cooling fluid inflow that has cooled the first processor 104, onto the second processor 106 and/or laterally with respect to the second processor 106 such that it bypasses the second processor. The first set of one or more channels 120₄, 120_{4,5} have a combined fluid inlet cross sectional area D₁, D'₁, and a combined fluid outlet cross sectional area D₂, D'₂. The combined fluid inlet cross sectional area D₁, D'₁ of the first set of one or more channels 120₄, 120_{4,5} is smaller than the combined fluid outlet cross sectional area D₂, D'₂ of the first set of one or more channels 120₄, 120_{4,5}.

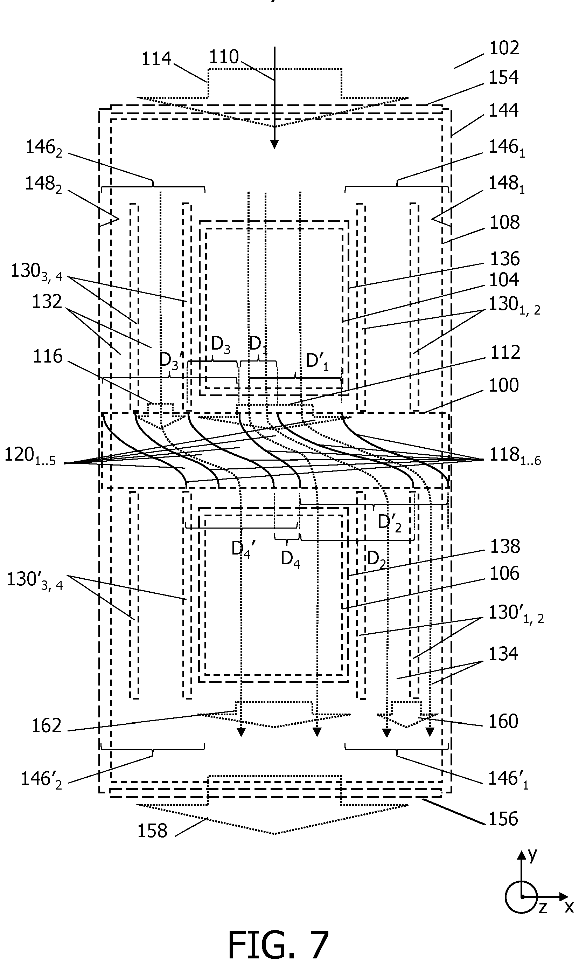

This example is illustrated in Fig. 7 and Fig. 11. For instance, in Fig. 7, the channel 120₄, i.e. the fourth channel from the left in Fig. 7, extracts from the first processor 104, cooling fluid that has cooled the first processor. The channel 120₄ has a fluid inlet cross sectional area D₁ that is smaller than its fluid outlet cross sectional area D₂. As explained above, this relative sizing of the channels improves the cooling of the first processor 104. Similarly, in Fig. 7, the first set of channels defined by the combination of channels 120₄ and 120s, also extract from the first processor 104, fluid that has cooled the first processor. The combined fluid inlet cross sectional area D'₁ of the first set of one or more channels defined by the combination of channels 120₄ and 120₅, is smaller than the combined fluid outlet cross sectional area D'₂ of this set of channels. Thus, this relative sizing of the channels also improves the cooling of the first processor 104. In a related example, the combined cross sectional area of the first set of one or more channels 120₄, 120_{4,5} increases monotonically between the combined fluid inlet and the combined fluid outlet. This improves the flow of cooling fluid through the cooling fluid deflector.

In one example, the foils define channels, and the relative sizes of the inlet and outlet cross sectional areas of the channels are defined so as to improve the cooling of the second processor 106. This example is similar to the previous example since it exploits the same principle of using the relative sizes of the cross sectional areas of the channels to improve the cooling of a processor. However, in this example, it is the cooling of the second processor that is improved. Moreover, the cooling is improved by controlling the supply of cooling fluid to a processor rather than by controlling the extraction of cooling fluid from a processor.

In this example, the cooling fluid deflector 100 comprises a plurality of foils 118. The foils define one or more channels 120, including: a second set of one or more channels 120₃, 120_{1..3} configured to feed a portion of the first portion 112 of the cooling fluid inflow that has cooled the first processor 104 and/or a portion of the second portion 116 of the cooling fluid inflow that has bypassed the first processor 104, onto the second processor 106. The second set of one or more channels 120₃, 120_{1..3} have a combined fluid inlet cross sectional area D₃, D'₃ and a combined fluid outlet cross sectional area D₄, D'₄. The combined fluid outlet cross sectional area D₄, D'₄ of the second set of one or more channels 120₃, 120_{1..3} is smaller than the combined fluid inlet cross sectional area D₃, D'₃ of the second set of one or more channels 120₃, 120_{1..3}.

This example is illustrated in Fig. 7 and Fig. 11. For instance, in Fig. 7, the channel 120₃, i.e. the third channel from the left in Fig. 7, feeds onto the second processor 106, a portion of the first portion 112 of the cooling fluid inflow that has cooled the first processor 104. The channel 120₃ has a fluid outlet cross sectional area D₄ that is smaller than its fluid inlet cross sectional area D₃. As explained above, this relative sizing of the channels improves the cooling of the second processor 106. Similarly, in Fig. 7, the second set of channels defined by the combination of channels 120₁, 120₂ and 120₃, feeds onto the second processor 106, a portion of the second portion 116 of the cooling fluid inflow that has bypassed the first processor 104, and also a portion of the first portion 112 of the cooling fluid inflow that has cooled the first processor 104. The former of these portions bypasses the first processor 104 by passing laterally with respect to the first processor 104. The combined fluid outlet cross sectional area D'₄ of the second set of one or more channels defined by the combination of channels 120₁, 120₂ and 120₃, is smaller than the combined fluid inlet cross sectional area D'₃ of this set of channels. Thus, this relative sizing of the channels improves the cooling of the second processor 106. In a related example, the combined cross sectional area of the second set of one or more channels 120₃, 120_{1..3} decreases monotonically between the combined fluid inlet and the combined fluid outlet. This improves the flow of cooling fluid through the cooling fluid deflector.

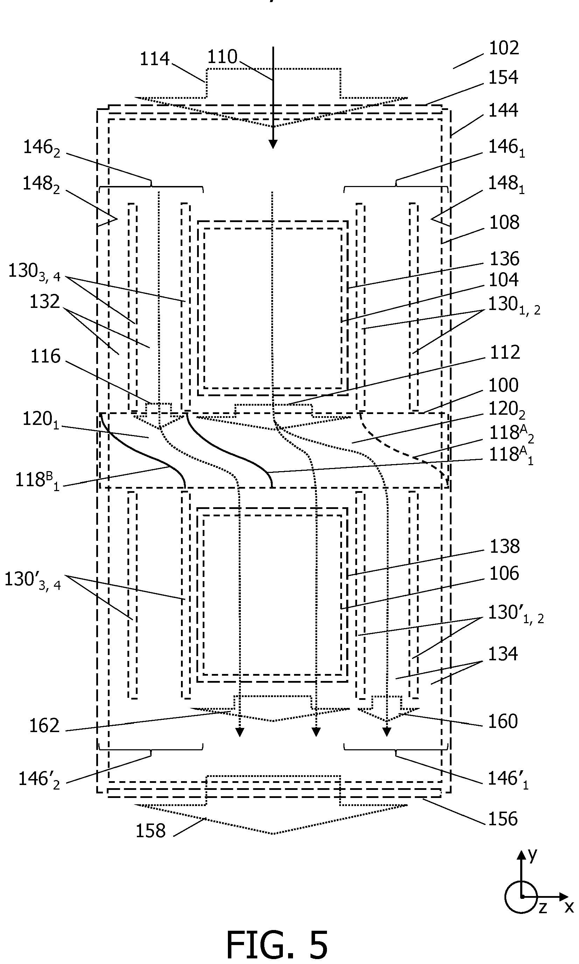

In one example, the cooling fluid deflector 100 is configured to cause the re-directing of the first portion 112 of the cooling fluid inflow such that at least a portion of the re-directed first portion 112 of the cooling fluid inflow flowing laterally across the plane 108 cools the second processor 106. For instance, in the example illustrated in Fig. 5, a downstream edge of the first foil 118^{A}₁ terminates within the lateral extent of the second processor 106. A similar effect may be obtained with other arrangements of the foils 118. For instance, a similar effect is obtained by the channel 120₃ that is defined by the foils 118₃ and 118₄ in the cooling fluid deflector 100 illustrated in Fig. 7.

In one example, the server 102 includes one or more memory boards, or memory blanking boards. In this example, the boards define memory board channel(s) that guide the second portion 116 of the cooling fluid inflow such that it bypasses the first processor 104, or that guide the re-directed first portion 112 of the cooling fluid inflow past the second processor 106. In this example, the foil(s) 118 adjoin one or more of the boards. The foil(s) may abut the board(s), or there may be a (small) gap between the foil(s) and the board(s). This arrangement reduces the leakage of cooling fluid between the memory boards and the foils, thereby improving the flow of cooling fluid.

In this example, the first processor 104 and the second processor 106 each comprise one or more memory boards 130, 130', or one or more memory blanking boards. The one or more boards 130, 130' are arranged laterally with respect to the corresponding processor 104, 106 such that the one or more boards extend along the server cooling fluid inflow direction 110 and outwards with respect to the plane 108.

In one variant of this example, the one or more boards 130 of the first processor 104 are separated from the first processor 104 to provide at least one memory board channel 132 for guiding the second portion 116 of the cooling fluid inflow such that it bypasses the first processor 104. At least one of the at least a second foil 118^{B}₁ of the cooling fluid deflector is configured to adjoin at least one of one or more corresponding boards 130'₄ of the second processor 106 for guiding the second portion 116 of the cooling fluid inflow that has bypassed the first processor 104 between the at least a second foil 118^{B}₁ and the one or more corresponding boards 130'₄ of the second processor 106. Examples of this arrangement of the foil(s) with respect to the memory boards are illustrated within the dashed oval box in the server 102 illustrated in Fig. 1.

In another variant of this example, the one or more boards 130' of the second processor 106 are separated from the second processor to provide at least one memory board channel 134 for guiding the at least a portion of the re-directed first portion 112 of the cooling fluid inflow that bypasses the second processor 106 past the second processor 106. At least one of the at least a first foil 118^{A}₁ of the cooling fluid deflector 100, 300 is configured to adjoin at least one of one or more corresponding boards 130₄ of the first processor 104 for guiding the at least a portion of the re-directed first portion 112 of the cooling fluid inflow between the one or more boards 130₄ of the first processor 104 and the at least a first foil 118^{A}₁. Examples of this arrangement of the foil(s) with respect to the memory boards are illustrated within the dashed rectangular box in the server 102 illustrated in Fig. 1.

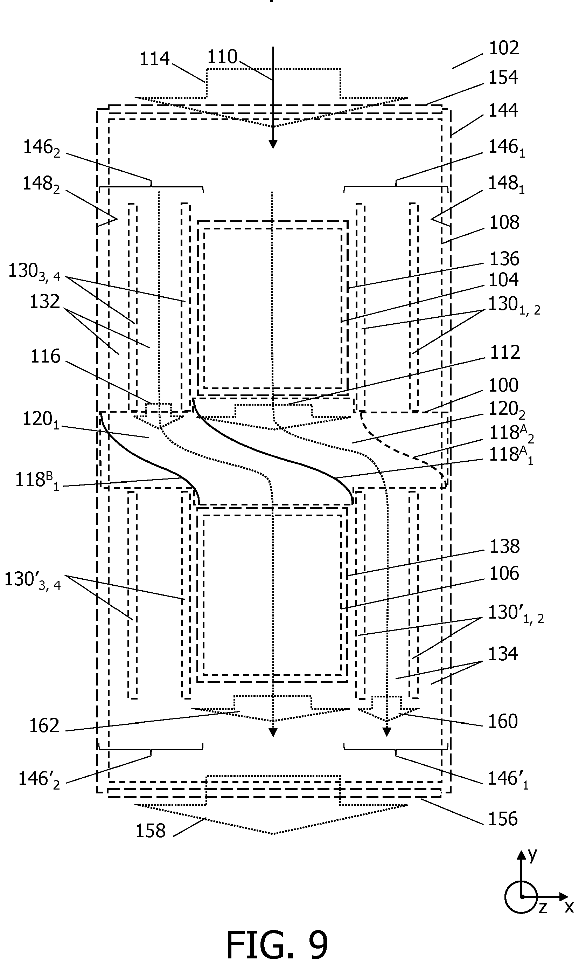

In one example, at least one of the foils 118 adjoins at least one of the processors. This arrangement reduces the leakage of cooling fluid between the processor and the corresponding foil, thereby improving the flow of cooling fluid in the server. An example of this arrangement is illustrated in the cooling fluid deflector in Fig. 9, and wherein an upstream edge of the first foil 118^{A}₁ adjoins the first processor 104 and a downstream edge of the first foil 118^{A}₁ adjoins the second processor 106.

In some examples, the first and second processors 104, 106, in the server 102 are thermally coupled to one or more heatsinks. Heatsinks are often used in servers to improve the extraction of heat from processors. A heatsink typically employs multiple heatsink elements, such as foils, fins, vanes, ridges, pillars, bumps, and so forth, that serve to extract heat. If a heatsink is employed, cooling fluid flows through the heatsink, e.g. through the heatsink elements, in order to cool the processor. In the absence of a heatsink, cooling fluid may pass over a processor in order to cool the processor.

In some examples, the first and second processors 104, 106 are thermally coupled to respective first and second heatsinks 136, 138, or the first and second processors are thermally coupled to a common heatsink 140. In these examples, the first portion 112 of the cooling fluid inflow passes through the first heatsink 136, or through a first portion of the common heatsink 140, respectively, for cooling the first processor 104. The at least a portion of the re-directed second portion 116 of the cooling fluid inflow passes through the second heatsink 138, or through a second portion of the common heatsink 140, respectively, for cooling the second processor 106.

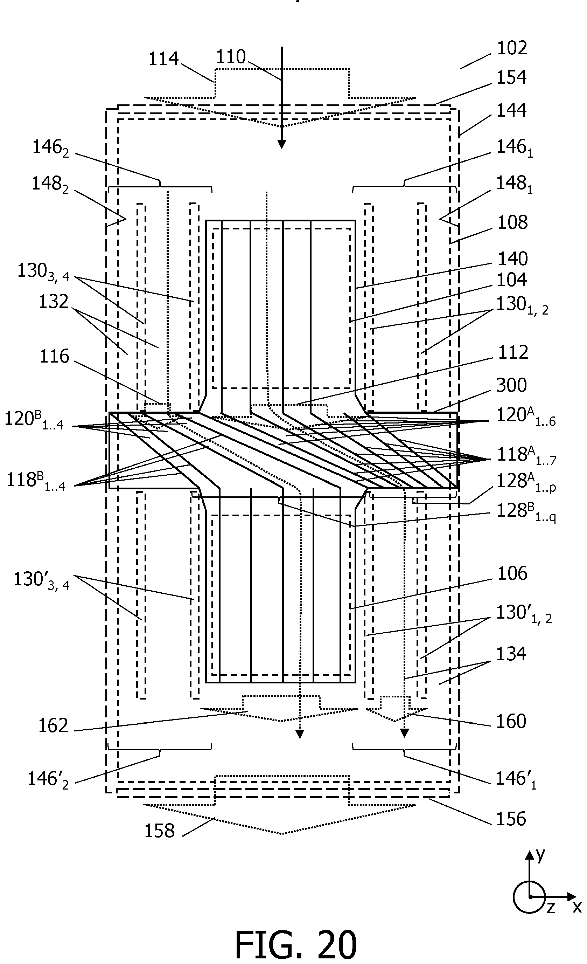

Examples of servers in which the processors 104, 106 are thermally coupled to heatsinks are illustrated in the Figures. For instance, in Fig. 1, the first processor 104 may be thermally coupled to a corresponding first processor heatsink 136, and the second processor 106 may be thermally coupled to a corresponding second processor heatsink 138. In the example illustrated in Fig. 20, the first and second processors may be thermally coupled to a common heatsink 140. In this example a first portion of the common heatsink 140 is in thermal contact with the first processor 104, and a second portion of the common heatsink is in thermal contact with the second processor 106.

In some examples, the foils 118 described above, are provided by the heatsink elements of one or more heatsinks. Using the heatsink elements to function as the foils may provide a more straightforward implementation of the cooling fluid deflector.

In these examples, the cooling fluid deflector 300 is provided by one or more heatsinks 126, 136', 138'. The one or more heatsinks 126, 136', 138' comprise a plurality of heatsink elements 128. A first group 128^{A}_{1..p} of the heatsink elements are configured to cause the re-directing of the first portion 112 of the cooling fluid inflow 114 that has cooled the first processor 104, laterally with respect to the server cooling fluid inflow direction 110 and across the plane 108. A second group 128^{B}_{1..q} of the heatsink elements are configured to cause the re-directing of the second portion 116 of the cooling fluid inflow 114 that has bypassed the first processor 104, laterally with respect to the server cooling fluid inflow direction 110 and across the plane 108.

An example of a heatsink 126 in which the heatsink elements are configured to cause the re-directing of the cooling fluid inflow in this manner is illustrated in Fig. 16. In this example, the heatsink elements 128 are provided in the form of foils 118. The foils provide the re-directing functions described above. As may be appreciated, the heatsink elements 128 may be provided as foils that have different profiles to the straight-edged foils illustrated in Fig. 16. For instance, the heatsink elements may have curved profiles, such as those illustrated in the foils 118 in Fig. 1. In other examples, the heatsink elements 128 may be provided in another form. For instance, the heatsink elements may instead be provided in the form of fins, vanes, ridges, pillars, bumps, and so forth, and wherein a shape, spacing, period, and size of the heatsink elements is arranged to provide the re-directing functions described above.

The heatsink 126 may be thermally coupled to various components, or subsystems. For instance, the heatsink 126 may be thermally coupled to a power supply component, or a power supply subsystem, or another component or subsystem. In some servers, power supply components, or power supply subsystems are arranged between the processors in order that they benefit from the cooling that is provided by the cooling fluid passing through the server, and so these may provide a suitable location for the cooling fluid deflector.

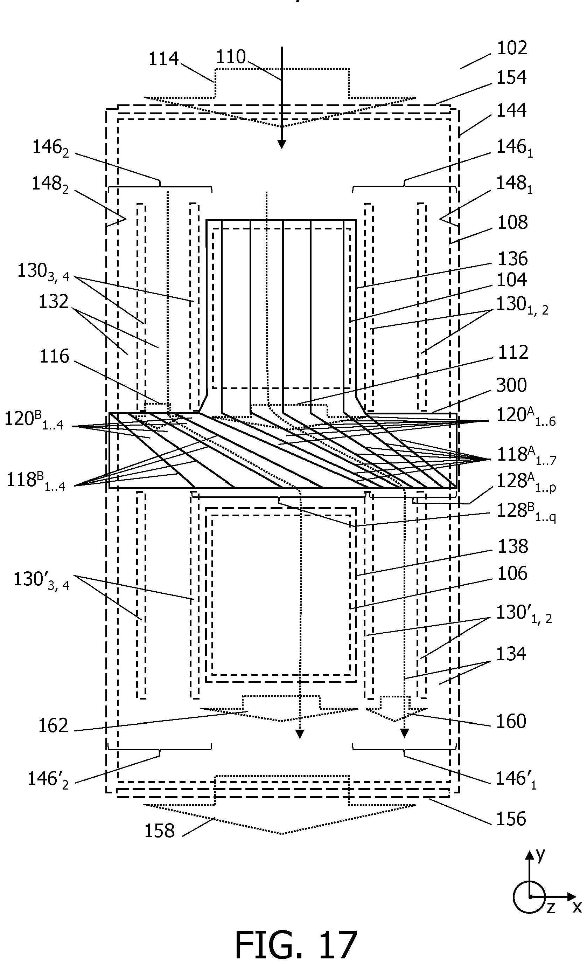

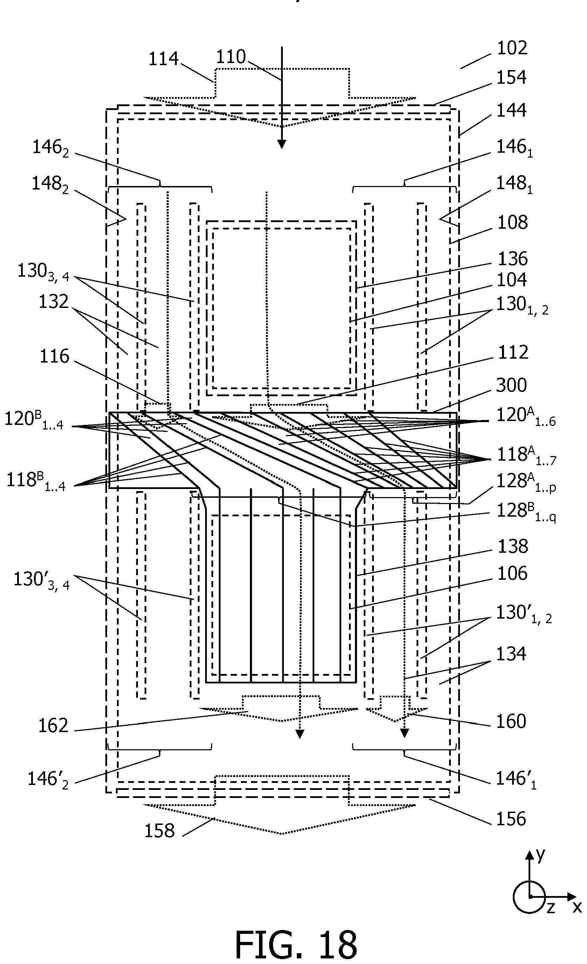

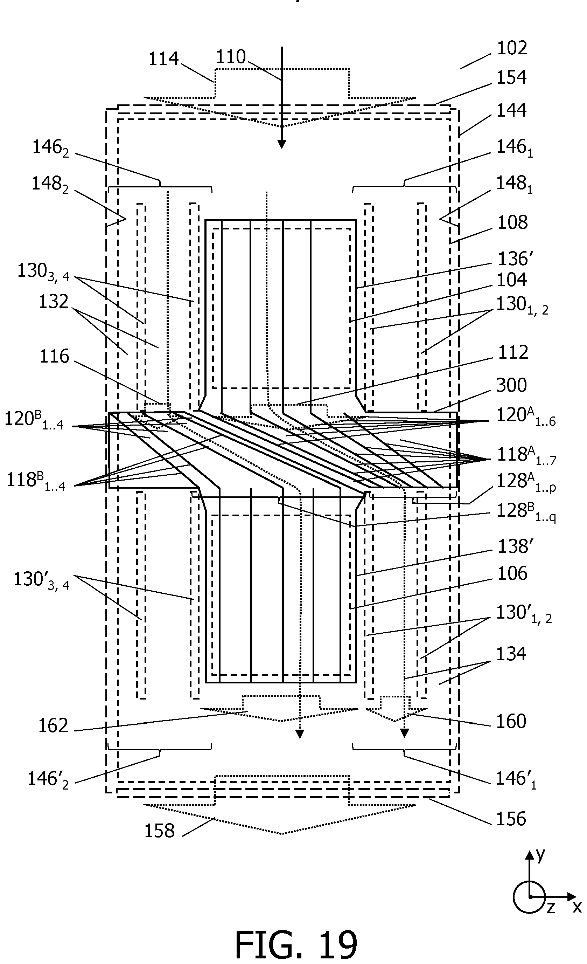

In one example, one or more heatsinks 126, 146', 138' are thermally coupled to the first processor 104 and/or the second processor 106. Thus, the heatsink elements of a first processor heatsink that is thermally coupled to the first processor, or heatsink elements of a second processor heatsink that is thermally coupled to the second processor, or the heatsink elements of a common heatsink that is thermally coupled to both the first and second processors 104, 106, may serve as the foils. An example in which the cooling fluid deflector is provided by a heatsink is illustrated in Fig. 17, and wherein the first processor heatsink 136 serves as the cooling fluid deflector 300. Similarly, in Fig. 18, the second processor heatsink 138 serves as the cooling fluid deflector 300. In the example illustrated in Fig. 19, the heatsink elements of a first processor heatsink 136' that is thermally coupled to the first processor 104, and also the heatsink elements of a second processor heatsink 138' that is thermally coupled to the second processor 106, serve as the foils. In the example illustrated in Fig. 20, the common processor heatsink 140 serves as the cooling fluid deflector 300. In this example, the heatsink elements of the common heatsink 140 that is thermally coupled to both the first and second processors 104, 106, serve as the foils.

In one example, the cooling fluid deflector is provided by a fluid-moving device 122 instead of the foils 118, or by the heatsink 126, described above. In this example, the fluid-moving device 122 is configured to generate a fluid stream 124 laterally with respect to the server cooling fluid inflow direction 110 and across the plane 108. The fluid stream 124 laterally with respect to the server cooling fluid inflow direction 110 and across the plane 108 is configured to cause the re-directing of the first and second portions 112, 116 of the cooling fluid inflow laterally with respect to the server cooling fluid inflow direction 110 and across the plane 108.

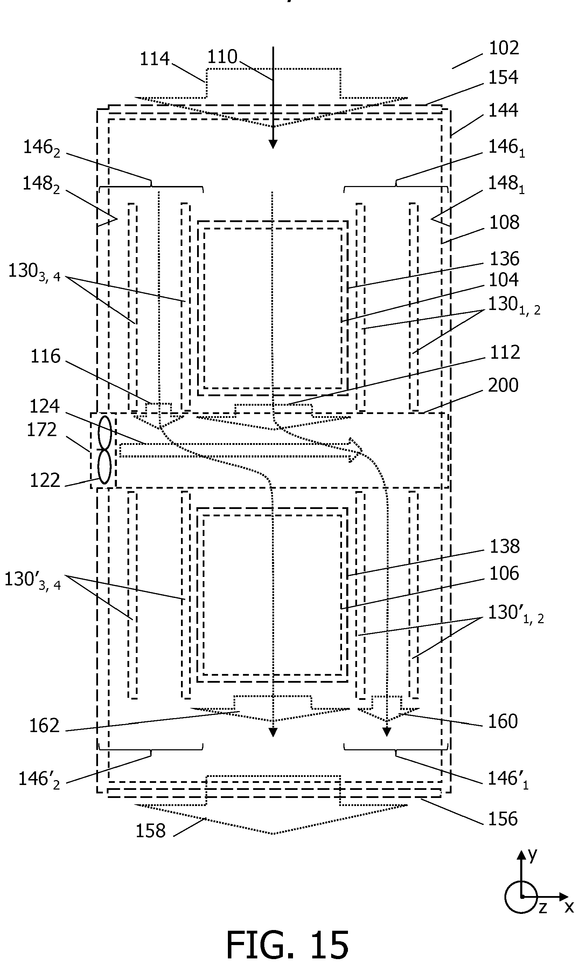

An example of this arrangement is illustrated in Fig. 15 wherein a fan 122 serves as the fluid-moving device. The fluid-moving device may alternatively be another device that moves fluid, such as a piezoelectric cooler, a pump, a loudspeaker, or an ionic thruster, and so forth. The housing 144 may include a second fluid inlet 172, and via which the fluid stream 124 is provided. The fluid-moving device may be coupled to the second fluid inlet 172.

In this example, the fluid-moving device 122 provides the fluid stream 124, as indicated via the horizontal dotted arrow. The fluid stream 124 interrupts the cooling fluid inflow along its path between the fluid inlet 154 and the fluid outlet 156 of the server. This re-directs the first portion 112 of the cooling fluid inflow 114 that has entered the server 102 along the server cooling fluid inflow direction 110 and has cooled the first processor 104, laterally with respect to the server cooling fluid inflow direction and across the plane 108 such that at least a portion of the re-directed first portion of the cooling fluid inflow bypasses the second processor 106 by passing laterally with respect to the second processor. The fluid stream 124 also re-directs the second portion 116 of the cooling fluid inflow 114 that has bypassed the first processor 104, laterally with respect to the server cooling fluid inflow direction 110 and across the plane 108 such that at least a portion of the re-directed second portion of the cooling fluid inflow flowing laterally across the plane 108 cools the second processor 106. The fluid outflow 158 exiting the server 102 includes the portion 160 of the cooling fluid inflow that has bypassed the second processor, and also the portion 162 of the cooling fluid inflow that has passed through the second processor, as described above in relation to Fig. 1.

In another set of examples, a kit of cooling fluid deflectors is provided. The kit may be used in the servers 102 described above. The kit includes the first cooling fluid deflector 100, 200, 300 described above. The kit also includes a second cooling fluid deflector 400 and/or a third cooling fluid deflector 500.

The kit of cooling fluid deflectors 100, 200, 300, 400, 500 may be used in a server 102 comprising a housing 144 and a first processor 104 and a second processor 106 wherein the first and second processors are arranged within the housing 144 on a plane 108 defined by a support layer of the first processor and/or the second processor and sequentially with respect to a server cooling fluid inflow direction 110 and wherein the processors are arranged within the housing to provide a gap 146_{1,2}, 146'_{1,2} between each processor and each of two opposing inner surfaces 148₁, 148₂ of the housing, the gaps being disposed laterally with respect to the corresponding processor 104, 106. The kit includes:
- the cooling fluid deflector 100, 200, 300 described above; and
- a second cooling fluid deflector 400 and/or a third cooling fluid deflector 500;
- wherein at least a portion of the second cooling fluid deflector 400 is configured to be disposed upstream of the first processor 104 with respect to the server cooling fluid inflow direction 110, and laterally with respect to the first processor, and wherein the second cooling fluid deflector 400 is configured to re-direct a portion of the cooling fluid inflow 114 that has entered the server 102 along the server cooling fluid inflow direction 110, from the gap 146₁ between the first processor 104 and a first inner surface 148₁ of the housing, laterally with respect to the server cooling fluid inflow direction and across the plane 108 such that at least a portion of the cooling fluid inflow 114 that has entered the server 102 is prevented from entering the gap 146₁ between the first processor 104 and the first inner surface 148₁ of the housing and instead cools the first processor 104 and/or increases a flow rate of the second portion 116 of the cooling fluid inflow 114 that bypasses the first processor 104; and
- wherein at least a portion of the third cooling fluid deflector 500 is configured to be disposed downstream of the second processor 106 with respect to the server cooling fluid inflow direction 110, and laterally with respect to the second processor 106, and wherein the third cooling fluid deflector 500 is configured to guide at least a portion of the re-directed second portion 116 of the cooling fluid inflow that has cooled the second processor 106 towards a second inner surface 148₂ of the housing for smoothing a transition of the at least a portion of the re-directed second portion 116 of the cooling fluid inflow that has cooled the second processor 106 between the second processor and the second inner surface 148₂ of the housing.

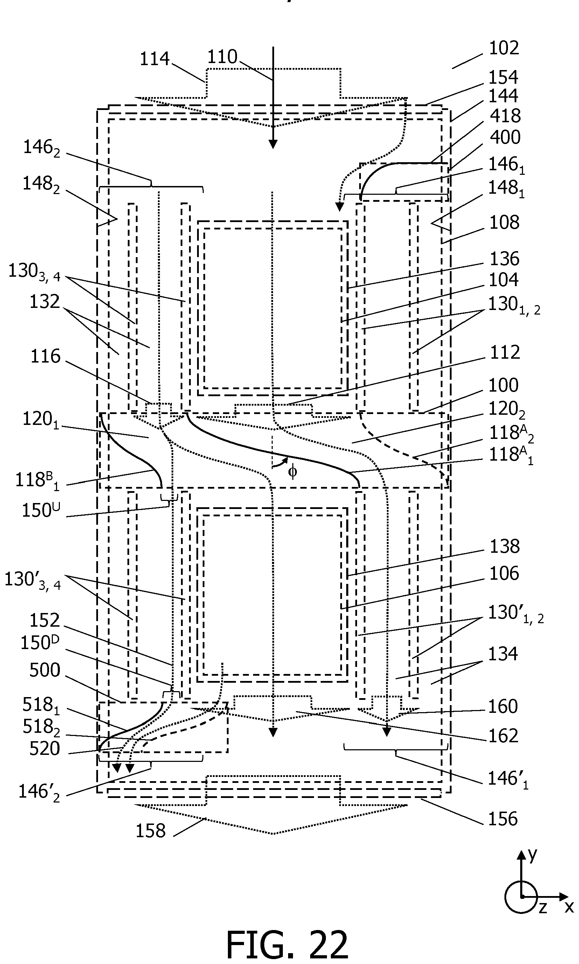

In the kit, the cooling deflector 100, 200, 300, which may be referred hereinafter as a first cooling fluid deflector, may be provided by any of the examples of the cooling fluid deflector 100, 200, or 300, described above. The second and third cooling fluid deflectors may re-direct, and guide, cooling fluid in similar directions, as illustrated in Fig. 21 and in Fig. 22. These direction may be different to the direction in which the first cooling fluid deflector 100, 200, 300 re-directs cooling fluid. The second and third cooling fluid deflectors may be provided by one or more foils, or by a portion of a heatsink, or by a fluid-moving device, in a similar manner to that described in relation to the first cooling fluid deflector 100, 200, 300. At least a portion of the second cooling fluid deflector is configured to be disposed upstream of the first processor 104 with respect to the server cooling fluid inflow direction 110. At least a portion of the third cooling fluid deflector 500 is configured to be disposed downstream of the second processor 106 with respect to the server cooling fluid inflow direction 110. The second and third cooling fluid deflectors provide additional improvements to the cooling of the first and second processors, as described below. The kit of cooling fluid deflectors is described below with reference to Fig. 21 - Fig. 24.

The kit of cooling fluid deflectors 100, 200, 300, 400, 500 may be used in a server 102 comprising a housing 144 and a first processor 104 and a second processor 106 wherein the processors are arranged within the housing to provide a gap 146_{1,2}, 146'_{1,2} between each processor and each of two opposing inner surfaces 148₁, 148₂ of the housing, the gaps being disposed laterally with respect to the corresponding processor 104, 106. This arrangement of the processors with respect to the housing is illustrated in Fig. 1 - Fig. 9, Fig. 15, and Fig. 17 - Fig. 22, e.g. on the left-hand and right-hand sides of the housing 144 illustrated in Fig. 21 - Fig. 23. The second cooling fluid deflector 400 and the third cooling fluid deflector 500 are illustrated in the upper and lower regions of Fig. 21 respectively, i.e. upstream of the first processor 104, and downstream of the second processor 106, respectively.

The second cooling fluid deflector 400 re-directs a portion of the cooling fluid inflow 114 that has entered the server 102 along the server cooling fluid inflow direction 110, from the gap 146₁ between the first processor 104 and a first inner surface 148₁ of the housing, laterally with respect to the server cooling fluid inflow direction and across the plane 108 such that at least a portion of the cooling fluid inflow 114 that has entered the server 102 is prevented from entering the gap 146₁ between the first processor 104 and the first inner surface 148₁ of the housing and instead cools the first processor 104 and/or increases a flow rate of the second portion 116 of the cooling fluid inflow 114 that bypasses the first processor 104. The first of these functions of the second cooling fluid deflector 400 is indicated via the dotted line in the upper region of Fig. 21, and which indicates the re-direction of the cooling fluid inflow 114 in the negative x direction. The second of these functions results from the second cooling fluid deflector 400 constricting the fluid flow. This, in-turn, improves the cooling of the second processor 106.

The third cooling fluid deflector 500 guides at least a portion of the re-directed second portion 116 of the cooling fluid inflow that has cooled the second processor 106 towards a second inner surface 148₂ of the housing for smoothing a transition of the at least a portion of the re-directed second portion 116 of the cooling fluid inflow that has cooled the second processor 106 between the second processor and the second inner surface 148₂ of the housing. In-turn, this improves the cooling of the second processor 106. This function of the third cooling fluid deflector 500 is indicated via the dotted line in the lower region of Fig. 21, and which indicates the re-direction of the cooling fluid inflow that has cooled the second processor 106 in the negative x direction.

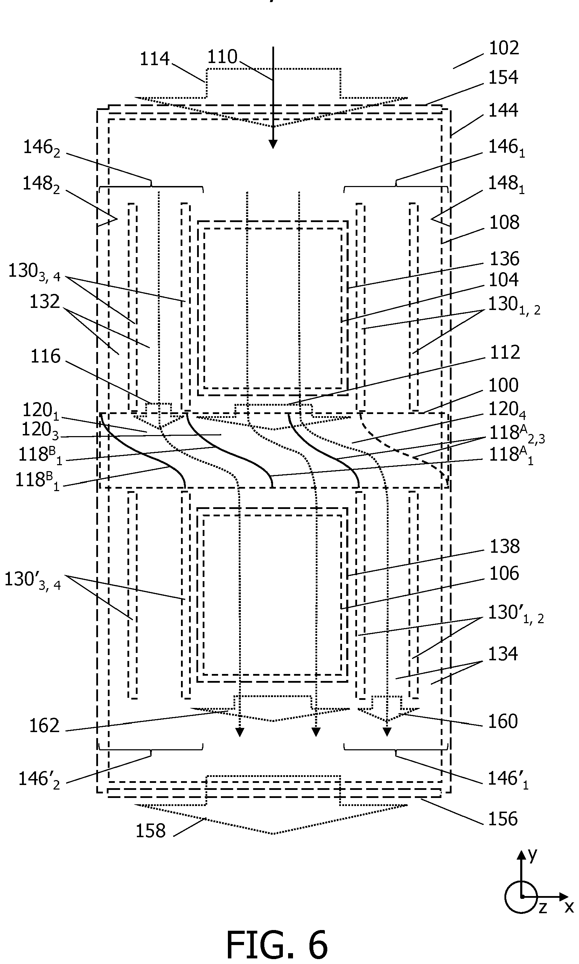

In the kit described above, the second cooling fluid deflector 400 improves the cooling fluid flow through the server by smoothing the flow from the first inner surface 148₁ of the housing to the first processor 104, thereby reducing the overall pressure drop between the fluid inlet 154 and the fluid outlet 156 of the server. The third cooling fluid deflector 500 improves the cooling fluid flow through the server by smoothing the transition of the at least a portion of the re-directed second portion 116 of the cooling fluid inflow that has cooled the second processor 106 between the second processor and the second inner surface 148₂ of the housing. In one example, the third cooling fluid deflector 500 presents a (monotonically) increasing cross sectional area to the cooling fluid 162 that has passed through the second processor 106. This has the effect of increasing the flow rate of the cooling fluid 162 as it exits the second processor, thereby further improving the cooling at the second processor 106, as described above in relation to the first cooling fluid deflector 100 illustrated in Fig. 6 and in Fig. 7.

As mentioned above, in some examples, the second and third cooling fluid deflectors are each provided by one or more foils. In the examples illustrated in Fig. 21 and Fig. 22, the second cooling fluid deflector 400 is provided by the foil 418, and the third cooling fluid deflector 500 is provided by the foil(s) 518₁ and/or 518₂. The foils are similar to the foils described above in relation to the first cooling fluid deflector 100. The second and third cooling fluid deflectors may also include one or more supports, as described in relation to Fig. 10, and as also illustrated via their dashed rectangular outlines in Fig. 21 and Fig. 22.

In one example the second cooling fluid deflector 400, the first cooling fluid deflector 100, 200, 300, and the third cooling fluid deflector 500 define an s-shaped path for the cooling fluid inflow 114 that has entered the server 102 along the server cooling fluid inflow direction 110. This arrangement makes guides the cooling fluid inflow through the server in a space-efficient manner.

In one example, at least one of the foils 518_{1,2} of the third cooling fluid deflector 500 is configured to adjoin a downstream edge of a memory board. For instance, the foil 518i may adjoin a downstream edge of the memory board 130'₄, as illustrated in Fig. 21. This further smooths the transition of the at least a portion of the re-directed second portion 116 of the cooling fluid inflow between the second processor and the second inner surface 148₂ of the housing.

In one example, at least one of the foils 518_{1,2} of the third cooling fluid deflector 500 is configured to adjoin a downstream edge of the second processor 106, or a downstream edge of the second processor heatsink 138. For instance, the foil 518₁ and/or the foil 518₂ may adjoin a downstream edge of the second processor heatsink 138, as illustrated in Fig. 21. This further smooths the transition of the at least a portion of the re-directed second portion 116 of the cooling fluid inflow between the second processor and the second inner surface 148₂ of the housing.

In one example, the third cooling fluid deflector 500 is configured to block at least a portion of the gap 146'₂ between the second processor 106 and the second inner surface 148₂ of the housing. This is illustrated in Fig. 21 and in Fig. 22 via the position of the foil 518₁ with respect to the gap 146'₂ and it serves to further improve the smoothing function of the third cooling fluid deflector 500. This blocking function may alternatively be achieved by adjoining the upstream edge of the foil 518₁ to a downstream edge of the second processor 106, or to a downstream edge of the second processor heatsink 138.

In one example, the third cooling fluid deflector 500 comprises one or more foils 518_{1, 2}, and the one or more foils define at least one channel 520 for guiding the at least a portion of the re-directed second portion 116 of the cooling fluid inflow 114 that has cooled the second processor 106 towards the second inner surface 148₂ of the housing. This is illustrated in Fig. 21 and in Fig. 22 via the positioning of the foil 518₂, which may define a channel between the foil 518₂ and the second inner surface 148₂ of the housing. Alternatively, the foils 518₁, and 518₂, may together define the channel 520, in this case the channel 520 being defined between the foils. The channel further smooths the transition of the at least a portion of the re-directed second portion 116 of the cooling fluid inflow between the second processor and the second inner surface 148₂ of the housing.

In one example, the first cooling fluid deflector 100 and the third cooling fluid deflector 500 are configured to provide an opening 150^{U}, 150^{D} in respective upstream and downstream positions with respect to the gap 146'₂ between the second processor 106 and the second inner surface 148₂ of the housing. The openings 150^{U}, 150^{D} are configured to pass at least a portion of the second portion 116 of the cooling fluid inflow that has bypassed the first processor 104 to provide a secondary fluid stream 152 that passes along the gap 146'₂ between the second processor 106 and the second inner surface 148₂ of the housing. The third cooling fluid deflector 500 is configured to combine the secondary fluid stream 152 with the guided at least a portion 116 of the re-directed second portion of the cooling fluid inflow that has cooled the second processor 106, for further smoothing the transition of the at least a portion of the re-directed second portion of the cooling fluid inflow that has cooled the second processor 106 between the second processor and the second inner surface 148₂ of the housing.

This example is illustrated in the lower portion of Fig. 22, and wherein the openings 150^{U}, 150^{D} are provided by leaving a space between a downstream edge of the second foil 118^{B}₁ of the first cooling fluid deflector 100, and the second processor 106, and by leaving a space between an upstream edge of the foil 518₁ of the third cooling fluid deflector 500 and the second processor 106, respectively. In this arrangement, the secondary fluid stream 152 that passes along the gap 146'₂ is combined with the guided at least a portion 116 of the re-directed second portion of the cooling fluid inflow that has cooled the second processor 106. This smooths the transition of the at least a portion of the re-directed second portion of the cooling fluid inflow that has cooled the second processor 106 between the second processor and the second inner surface 148₂ of the housing. In this example, the combining function is performed by the foils 518₁ and/or 518₂.

In one example, the first and second processor 104, 106 each comprise one or more memory boards 130, 130', or one or more memory blanking boards. The boards 130, 130' are arranged laterally with respect to the corresponding processor 104, 106 and within at least one of the corresponding gaps 146_{1,2}, 146'_{1,2} such that the one or more boards extend along the server cooling fluid inflow direction 110 and outwards with respect to the plane 108. If memory board(s) 130'_{3, 4} are arranged in the gap 146'₂, the secondary fluid stream 152 may also serve to improve the cooling of the memory boards.

In a related example, the first and/or second and/or third cooling fluid deflector provide a gap that facilitates cooling fluid to flow over the boards that are arranged within the gap(s). This serves to cool the memory devices that are coupled to the memory boards. The first and/or second and/or third cooling fluid deflector may be provided by a foil that includes a void, and wherein the void serves as the gap, for example.

In one example, the gap 146₁ between the first processor 104 and the first inner surface 148₁ of the housing is relatively smaller than the gap 146₂ between the first processor 104 and the second inner surface 148₂ of the housing. As described above, the second cooling fluid deflector 400 is configured to prevent at least a portion of the cooling fluid inflow 114 that has entered the server 102 from entering the gap 146₁ between the first processor 104 and the first inner surface 148₁ of the housing. The effect of defining the relative sizes of the gaps 146₁ and 146₂ in this manner is that the second cooling fluid deflector 400 blocks off at least some of the relatively smaller gap 146₁. In this example, blocking the relatively smaller gap 146₁ serves to increase the fluid flow to the first processor 104, which improves the cooling of the first processor, whilst also minimising the reduction in the fluid flow through the server, which improves the cooling of both the first and second processors.

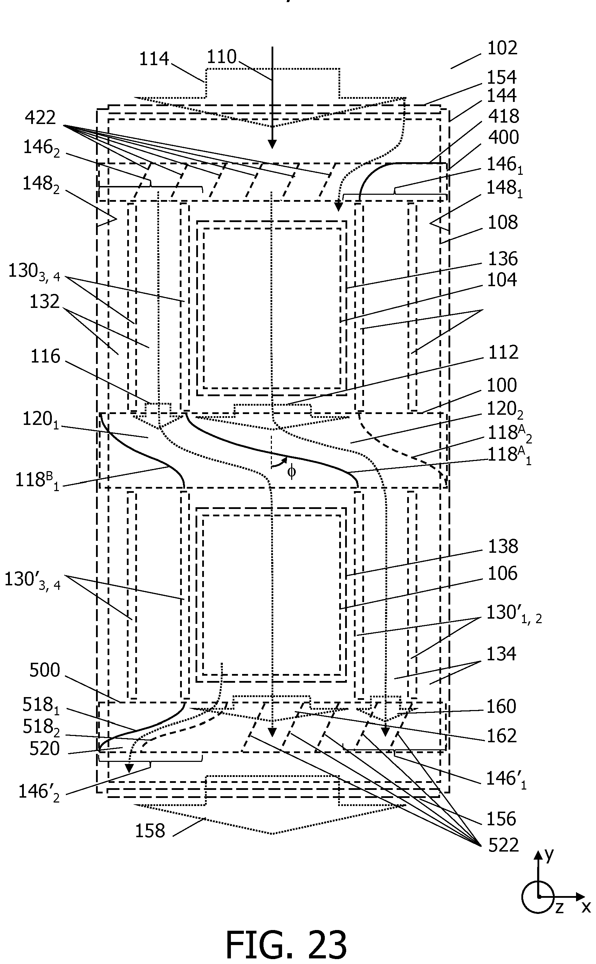

In one example, the second cooling fluid deflector 400 and/ or the third cooling fluid deflector 500, each include one or more steering foils 422, 522. The one or more steering foils 422 of the second cooling fluid deflector 400 guide a portion of the portion of the cooling fluid inflow 114 that has entered the server 102 along the server cooling fluid inflow direction 110, laterally across the plane and towards the second inner surface 148₂ of the housing 144. This is in a similar/ same direction to the re-direction provided by the foil 418. In so doing, the one or more steering foils 422 may increase a flow rate of the second portion 116 of the cooling fluid inflow 114 that bypasses the first processor 104. The one or more steering foils 522 the third cooling fluid deflector 500 guide at least a portion of the re-directed second portion 116 of the cooling fluid inflow 114 that has cooled the second processor 106, and/or at least some of the portion 160 of the cooling fluid inflow that has bypassed the second processor towards the second inner surface 148₂ of the housing. This may be in a similar/ same direction to the re-direction provided by the foil 518. In so doing, the one or more steering foils 522 may smooth and further improve the fluid flow in the server fluid outflow 158. This example is illustrated in Fig. 23, and which includes the foil(s) 422, and the foil(s) 522.

In one set of examples, a baffle is provided. The baffle may be used in the servers 102 described above. The baffle includes the first cooling fluid deflector 100, 200, 300, and the second and/or third cooling fluid deflectors 400, 500. The baffle corresponds to the kit described above, and additionally includes a support. The first and second and/or third cooling fluid deflectors are coupled to the support.

The baffle may be used in a server 102 comprising a housing 144 and a first processor 104 and a second processor 106 wherein the first and second processors are arranged within the housing on a plane 108 defined by a support layer of the first processor and/or the second processor and sequentially with respect to a server cooling fluid inflow direction 110 and wherein the processors are arranged within the housing to provide a gap 146_{1,2}, 146'_{1,2} between each processor and each of two opposing inner surfaces 148₁, 148₂ of the housing, the gaps being disposed laterally with respect to the corresponding processor. The baffle comprises:
- a support; and
- the cooling fluid deflector 100, 200, 300; and
- a second cooling fluid deflector 400 and/or a third cooling fluid deflector 500;
- wherein the cooling fluid deflector 100, 200, 300 and the second cooling fluid deflector 400 and/or the third cooling fluid deflector 500, are coupled to the support; and
- wherein at least a portion of the second cooling fluid deflector 400 is configured to be disposed upstream of the first processor 104 with respect to the server cooling fluid inflow direction 110, and laterally with respect to the first processor, and wherein the second cooling fluid deflector 400 is configured to re-direct a portion of the cooling fluid inflow 114 that has entered the server 102 along the server cooling fluid inflow direction 110 via a fluid inlet 154 in the housing 144, from the gap 146₁ between the first processor 104 and a first inner surface 148₁ of the housing, laterally with respect to the server cooling fluid inflow direction and across the plane 108 such that at least a portion of the cooling fluid inflow 114 that has entered the server 102 is prevented from entering the gap 146₁ between the first processor 104 and the first inner surface 148₁ of the housing and instead cools the first processor 104 and/or increases a flow rate of the second portion 116 of the cooling fluid inflow 114 that bypasses the first processor 104; and
- wherein at least a portion of the third cooling fluid deflector 500 is configured to be disposed downstream of the second processor 106 with respect to the server cooling fluid inflow direction 110, and laterally with respect to the second processor, and wherein the third cooling fluid deflector 500 is configured to guide at least a portion of the re-directed second portion of the cooling fluid inflow that has cooled the second processor 106 towards a second inner surface 148₂ of the housing for smoothing a transition of the at least a portion of the re-directed second portion of the cooling fluid inflow that has cooled the second processor 106 between the second processor and the second inner surface 148₂ of the housing.

The baffle may be inserted within a server, i.e. within a housing of the server, in order to improve the flow of cooling fluid in the server. The arrangement of the cooling fluid deflectors of the baffle corresponds to their arrangement in the kit described above, and is therefore not duplicated here. As mentioned above, the baffle includes a support. The support serves to position the cooling fluid deflectors in their intended positions with respect to the processors etc. in the server 102. The support therefore facilitates a straightforward fitting of the baffle into a server. The support may be formed from a material such as a metal, or a polymer. In one example, the support, and the cooling fluid deflectors are formed from a single piece of material. For instance, the support, and also the cooling fluid deflectors may be formed from a single piece of a polymer material, e.g. via injection moulding.

In one set of examples, a cover for a server is provided. The cover may be used as a cover of the servers 102 described above. The cover includes the kit of cooling fluid deflectors described above, and the cooling fluid deflectors are coupled to the cover.

The cover 142 may be used in a server 102 comprising a housing 144 and a first processor 104 and a second processor 106 wherein the first and second processors are arranged within the housing on a plane 108 defined by a support layer of the first processor and/or the second processor and sequentially with respect to a server cooling fluid inflow direction 110 and wherein the processors are arranged within the housing to provide a gap 146_{1,2}, 146'_{1,2} between each processor and each of two opposing inner surfaces 148₁, 148₂ of the housing, the gaps being disposed laterally with respect to the corresponding processor, wherein the cover 142 comprises the kit of cooling fluid deflectors 100, 200, 300, 400, 500 described above; and
- wherein the cooling fluid deflector 100, 200, 300 and the second cooling fluid deflector 400 and/or the third cooling fluid deflector 500 are coupled to the cover 142 and arranged such that when the cover is coupled to the server 102:
   at least a portion of the cooling fluid deflector 100, 200, 300 is disposed between the first processor 104 and the second processor 106; and
   at least a portion of the second cooling fluid deflector 400 is disposed upstream of the first processor 104 with respect to the server cooling fluid inflow direction 110, and laterally with respect to the first processor; and
   at least a portion of the third cooling fluid deflector 500 is disposed downstream of the second processor 106 with respect to the server cooling fluid inflow direction 110, and laterally with respect to the second processor.

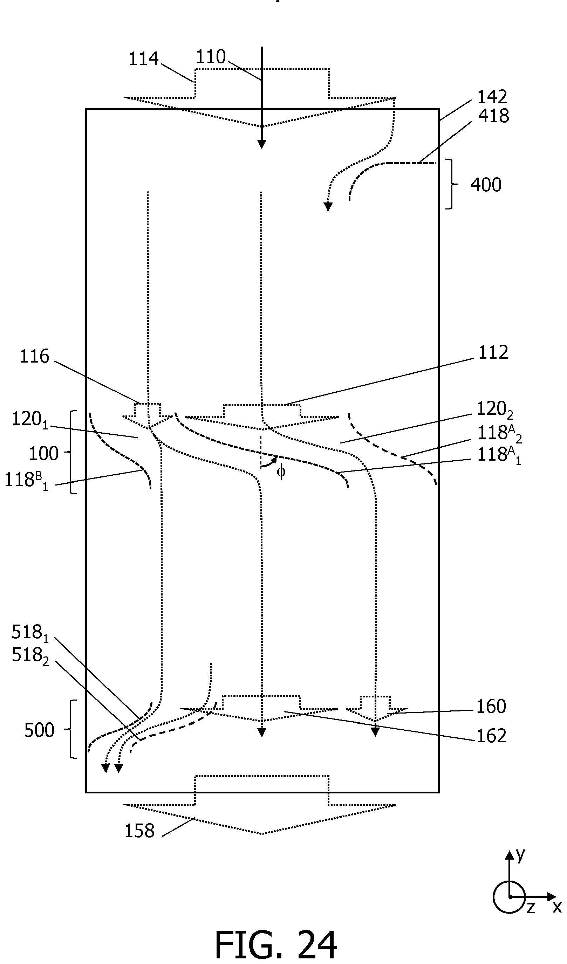

An example of the cover 142 is illustrated in Fig. 24. The cover may be used to improve the flow of cooling fluid in the servers described above, such as the server 102 illustrated in Fig. 21. The arrangement of the cooling fluid deflectors of the cover corresponds to their arrangement in the kit described above, and is therefore not duplicated here. The cover serves to position the cooling fluid deflectors with respect to the first and second processors, and so forth, in the server 102. The cover therefore facilitates a straightforward fitting of the cooling fluid deflectors into a server. The cover may be formed from a material such as a metal, or a polymer. In one example, the cover, and the cooling fluid deflectors are formed from a single piece of material. For instance, the support, and also the cooling fluid deflectors may be formed from a single piece of a polymer material, e.g. via injection moulding.

In one set of examples, a server 102 is provided. The server may include the cooling fluid deflectors 100, 200, 300 described above, or the kit of cooling fluid deflectors 100, 200, 300, 400, 500 described above, or the baffle described above, or the cover 142 described above. One or more features of the cooling fluid deflectors described above may be included in the server in accordance with this set of examples and they are not duplicated here for brevity.

In one set of examples, a cooling fluid deflector 100, 300 is provided. The cooling fluid deflector 100, 300 may be used in a server 102 that includes a first processor 104 and a second processor 106. The cooling fluid deflector includes a plurality of foils 118. The foils define one or more channels 120, including:
- a first set of one or more channels 120₄, 120_{4,5} configured to feed a portion of a cooling fluid inflow 112 that has cooled the first processor 104, onto the second processor 106 and/or laterally with respect to the second processor 106 such that it bypasses the second processor;
- a second set of one or more channels 120₃, 120_{1..3} configured to feed a portion of the cooling fluid inflow 112 that has cooled the first processor 104 and/or a portion of a second portion 116 of a cooling fluid inflow that has bypassed the first processor 104, onto the second processor 106.

In this set of examples, the first set of one or more channels 120₄, 120_{4,5} have a combined fluid inlet cross sectional area D₁, D'₁, and a combined fluid outlet cross sectional area D₂, D'₂, and the combined fluid inlet cross sectional area D₁, D'₁ of the first set of one or more channels 120₄, 120_{4,5} is smaller than the combined fluid outlet cross sectional area D₂, D'₂ of the first set of one or more channels 120₄, 120_{4,5}. Alternatively, or additionally, the second set of one or more channels 120₃, 120_{1..3} have a combined fluid inlet cross sectional area D₃, D'₃ and a combined fluid outlet cross sectional area D₄, D'₄, and the combined fluid outlet cross sectional area D₄, D'₄ of the second set of one or more channels 120₃, 120_{1..3} is smaller than the combined fluid inlet cross sectional area D₃, D'₃ of the second set of one or more channels 120₃, 120_{1..3}.

Examples of cooling fluid deflectors in accordance with this set of examples are illustrated in Fig. 7, and in Fig. 11. The effect of defining the relative sizes of the channels in this manner is to improve the cooling of one or both of the processors, as described above in relation to these Figures. In general, the cooling fluid deflector may be provided by the cooling fluid deflectors 100, 300 described above that include foils 118. The foils may have various profiles, and the foils may be formed from different materials, as described above. The foils 118 may be provided by the heatsink elements of one or more heatsinks, as described above in relation to Fig. 16. The cooling fluid deflectors in accordance with this set of examples may also include one or more supports, as described in relation to Fig. 10, and as also illustrated via their dashed rectangular outlines in Fig. 7 and Fig. 11.

In one set of examples, a server 102 is provided. The server 102 includes a plurality of foils. The foils re-direct a portion of the cooling fluid inflow 114 that has entered the server housing 144 along the server cooling fluid inflow direction 110 via the fluid inlet 154 such that a first portion 112 of the cooling fluid inflow that has entered the server housing cools the first processor 104, and such that a second portion 116 of the cooling fluid inflow 114 that has entered the server housing bypasses the first processor 104. This function is provided by the foil 418 of the second cooling fluid deflector 400 described above with reference to Fig. 21 and Fig. 22, and it likewise improves the cooling fluid flow through the server by smoothing the flow from the first inner surface 148₁ of the housing to the first processor 104, thereby reducing the overall pressure drop between the fluid inlet 154 and the fluid outlet 156 of the server. In this set of examples, the foils also re-direct the first portion 112 of the cooling fluid inflow that has cooled the first processor 104 such that at least a portion of the re-directed first portion of the cooling fluid inflow bypasses the second processor 106 by passing laterally with respect to the second processor. This function is provided by the first foil(s) 118^{A}_{1..i} of the first cooling fluid deflector 100, 300 described above, and it likewise reduces the impact of heat generated by the first processor on the second processor, or in other words, it improves the cooling of the second processor. In this set of examples, the foils also re-direct the second portion 116 of the cooling fluid inflow that has bypassed the first processor 104 such that at least a portion of the re-directed second portion of the cooling fluid inflow flowing laterally across the plane 108 cools the second processor 106. This function is provided by the second foil(s) 118^{B}_{1..j} of the first cooling fluid deflector 100, 300 described above, and it likewise improves the cooling of the second processor because the second processor is cooled using the re-directed second portion of the cooling fluid inflow that has bypassed the first processor. Thus, together, these features improve the processing performance of the second processor, which in-turn has the synergistic effect of improving the overall processing performance of the server.

In this set of examples, the server 102 may include one or more features of the servers 102, or the foils 118, 418, 518, described above. These are not duplicated here for brevity. A list of Examples in accordance with this set of examples is described below.

Example 1: A server 102 comprising:
- a server housing 144, the server housing comprising a fluid inlet 154 and a fluid outlet 156;
- a first processor 104 and a second processor 106; and
- a plurality of foils 118, 418, 518;
- wherein the first and second processors 104, 106 are arranged within the server housing 144 sequentially with respect to a server cooling fluid inflow direction 110 of a cooling fluid inflow 114 entering the server housing via the fluid inlet 154;
- wherein the foils 118, 418 are configured to:
   re-direct a portion of the cooling fluid inflow 114 that has entered the server housing 144 along the server cooling fluid inflow direction 110 via the fluid inlet 154 such that a first portion 112 of the cooling fluid inflow that has entered the server housing cools the first processor 104, and such that a second portion 116 of the cooling fluid inflow 114 that has entered the server housing bypasses the first processor 104;
   re-direct the first portion 112 of the cooling fluid inflow that has cooled the first processor 104 such that at least a portion of the re-directed first portion of the cooling fluid inflow bypasses the second processor 106 by passing laterally with respect to the second processor;
   re-direct the second portion 116 of the cooling fluid inflow that has bypassed the first processor 104 such that at least a portion of the re-directed second portion of the cooling fluid inflow flowing laterally across the plane 108 cools the second processor 106.

Example 1 is illustrated in e.g. Fig. 21 and in Fig. 22, e.g. via the foils 418, and 118.

Example 2: The server 102 according to Example 1, wherein the processors 104, 106 are arranged within the housing 144 to provide a gap 146_{1,2}, 146'_{1,2} between each processor and each of two opposing inner surfaces 148₁, 148₂ of the housing, the gaps being disposed laterally with respect to the corresponding processor; and
- wherein the re-directing of the portion of the cooling fluid inflow 114 that has entered the server housing 144 along the server cooling fluid inflow direction 110 via the fluid inlet 154 such that a first portion 112 of the cooling fluid inflow that has entered the server housing cools the first processor 104, and such that a second portion 116 of the cooling fluid inflow that has entered the server housing bypasses the first processor 104, comprises:
   preventing at least a portion of the cooling fluid inflow 114 from entering the gap 146₁ between the first processor 104 and a first inner surface 148₁ of the housing.

Example 2 is illustrated in e.g. Fig. 21 and Fig. 22, via the positioning of the foil 418 with respect to the gap 146₁.

Example 3: The server 102 according to Example 1 or Example 2, wherein the processors 104, 106 are arranged within the housing 144 to provide a gap 146_{1,2}, 146'_{1,2} between each processor and each of two opposing inner surfaces 148₁, 148₂ of the housing, the gaps being disposed laterally with respect to the corresponding processor; and
- wherein the foils 518 are further configured to:
   guide at least a portion of the re-directed second portion of the cooling fluid inflow that has cooled the second processor 106 towards a second inner surface 148₂ of the housing for smoothing a transition of the at least a portion of the re-directed second portion of the cooling fluid inflow that has cooled the second processor 106 between the second processor and the second inner surface 148₂ of the housing.

This function is provided by the foil(s) 518₁ and/or 518₂ of the third cooling fluid deflector 500 described above with reference to Fig. 21 and Fig. 22, and it likewise improves the cooling of the second processor 106.

Example 4: The server 102 according to Example 3, wherein the foils 518 are further configured to provide an opening 150^{U}, 150^{D} in respective upstream and downstream positions with respect to the gap 146'₂ between the second processor 106 and the second inner surface 148₂ of the housing; and
- wherein the openings 150^{U}, 150^{D} are configured to pass at least a portion of the re-directed second portion of the cooling fluid inflow that has bypassed the first processor 104 to provide a secondary fluid stream 152 that passes along the gap 146'₂ between the second processor 106 and the second inner surface 148₂ of the housing; and
- wherein the third cooling fluid deflector 500 is further configured to combine the secondary fluid stream 152 with the guided at least a portion of the re-directed
second portion of the cooling fluid inflow that has cooled the second processor 106, for further smoothing the transition of the at least a portion of the re-directed second portion of the cooling fluid inflow that has cooled the second processor 106 between the second processor and the second inner surface 148₂ of the housing.

This function is provided by the openings 150^{U}, 150^{D} and the resulting secondary fluid stream 152 described above with reference to Fig. 22, and it likewise further improves the cooling of the second processor 106.

Example 5: The server 102 according to any one of Examples 1 - 4, wherein the foils 518 are further configured to block at least a portion of the gap 146'₂ between the second processor 106 and the second inner surface 148₂ of the housing.

This function is illustrated by the positioning of the foil 518₁ with respect to the gap 146'₂ in Fig. 21 and Fig. 22 and it likewise serves to further improve the smoothing function of the foil(s) 518_{1,2}.

Example 6: The server 102 according to any one of Examples 1 - 5, wherein:
- the re-directing a portion of the cooling fluid inflow 114 that has entered the server housing 144 along the server cooling fluid inflow direction 110 via the fluid inlet 154 such that a first portion 112 of the cooling fluid inflow that has entered the server housing cools the first processor 104, and such that a second portion 116 of the cooling fluid inflow that has entered the server housing bypasses the first processor 104, comprises:
   re-directing a portion of the cooling fluid inflow 114 that has entered the server housing 144 along the server cooling fluid inflow direction 110, from the gap 146₁ between the first processor 104 and a first inner surface 148₁ of the housing, laterally with respect to the server cooling fluid inflow direction 110 and across a plane 108 defined by a support layer of the first processor and/or the second processor;
   and/or
- the re-directing the first portion 112 of the cooling fluid inflow that has cooled the first processor 104 such that at least a portion of the re-directed first portion of the cooling fluid inflow bypasses the second processor 106 by passing laterally with respect to the second processor, comprises:
   re-directing the first portion 112 of the cooling fluid inflow that has entered the server housing 144 along the server cooling fluid inflow direction 110 and has cooled the first processor 104, laterally with respect to the server cooling fluid inflow direction and across the plane 108;
   and/or
- the re-directing the second portion 116 of the cooling fluid inflow that has bypassed the first processor 104 such that at least a portion of the re-directed second portion of the cooling fluid inflow flowing laterally across the plane 108 cools the second processor 106, comprises:
   re-directing the second portion 116 of the cooling fluid inflow that has bypassed the first processor 104, laterally with respect to the server cooling fluid inflow direction 110 and across the plane 108 and/or
- the guiding at least a portion of the re-directed second portion of the cooling fluid inflow that has cooled the second processor 106 towards a second inner surface 148₂ of the housing, comprises:
   re-directing the at least a portion of the re-directed second portion of the cooling fluid inflow that has cooled the second processor 106 laterally with respect to the server cooling fluid inflow direction 110 and across the plane 108 towards the second inner surface 148₂ of the housing.

These functions are described above with reference to the foil(s) 418 of the second cooling fluid deflector, the foil(s) 118 of the first cooling fluid deflector, and the foil(s) 518 of the third cooling fluid deflector.

Example 7: The server 102 according to any one of Examples 1 - 6; wherein the server further comprises one or more heatsinks 126, 136', 138', 140, and wherein the heatsink comprises a plurality of heatsink elements 128;
- wherein a first group 128^{A}_{1..p} of the heatsink elements define the one or more foils 118 that re-direct the first portion 112 of the cooling fluid inflow that has cooled the first processor 104 such that at least a portion of the re-directed first portion of the cooling fluid inflow bypasses the second processor 106 by passing laterally with respect to the second processor; and
- wherein a second group 128^{B}_{1..p} of the heatsink elements define the one or more foils 118 that re-direct the second portion 116 of the cooling fluid inflow that has bypassed the first processor 104 such that at least a portion of the re-directed second portion of the cooling fluid inflow flowing laterally across the plane 108 cools the second processor 106.

The functions of the first and second groups of heatsink elements 128 are described above with reference to Fig. 16 - Fig. 20.

Example 8: The server 102 according to any one of Examples 1 - 7, wherein the first and second processors 104, 106 are thermally coupled to respective first and second heatsinks 136, 138, 136', 138', or wherein the first and second processors are thermally coupled to a common heatsink 140; and
- wherein the first portion 112 of the cooling fluid inflow passes through the first heatsink 136, 136', or through a first portion of the common heatsink 140, respectively, for cooling the first processor 104; and
- wherein the at least a portion of the re-directed second portion of the cooling fluid inflow passes through the second heatsink 138, 138', or through a second portion of the common heatsink 140, respectively, for cooling the second processor 106.

The heatsinks in accordance with Example 8 are described above with reference to Fig. 17 - Fig. 20.

It is noted that in another set of examples, the server 102 may alternatively include foils that serve the function of the second and third cooling fluid deflectors described above. Thus, a further Example 9 is provided below.

Example 9: A server 102 comprising:
- a server housing 144, the server housing comprising a fluid inlet 154 and a fluid outlet 156;
- a first processor 104 and a second processor 106; and
- a plurality of foils 118, 418, 518;
- wherein the first and second processors 104, 106 are arranged within the server housing 144 sequentially with respect to a server cooling fluid inflow direction 110 of a cooling fluid inflow 114 entering the server housing via the fluid inlet 154; and wherein the processors 104, 106 are arranged within the housing 144 to provide a gap 146_{1,2}, 146'_{1,2} between each processor and each of two opposing inner surfaces 148₁, 148₂ of the housing, the gaps being disposed laterally with respect to the corresponding processor; and
- wherein the foils 118, 418 are configured to:
   re-direct a portion of the cooling fluid inflow 114 that has entered the server housing 144 along the server cooling fluid inflow direction 110 via the fluid inlet 154 such that a first portion 112 of the cooling fluid inflow that has entered the server housing cools the first processor 104, and such that a second portion 116 of the cooling fluid inflow 114 that has entered the server housing bypasses the first processor 104; and
- wherein the foils 518 are further configured to:
   guide at least a portion of the re-directed second portion of the cooling fluid inflow that has cooled the second processor 106 towards a second inner surface 148₂ of the housing for smoothing a transition of the at least a portion of the re-directed second portion of the cooling fluid inflow that has cooled the second processor 106 between the second processor and the second inner surface 148₂ of the housing.

Example 9 is illustrated in e.g. Fig. 21 and Fig. 22, wherein these functions of the foils are provided by the second cooling fluid deflector 400 and the third cooling fluid deflector 500.

The above examples are to be understood as illustrative of the present disclosure, and not restrictive. Further examples are also contemplated. For instance, the examples described in relation to a cooling fluid deflector, may also be provided in a kit that includes the cooling fluid deflectors, or in a baffle that includes the cooling fluid deflector, or in a cover that includes the cooling fluid deflector, or in a server that includes the cooling fluid deflector, in a corresponding manner. It is to be understood that a feature described in relation to any one example may be used alone, or in combination with other described features, and may be used in combination with one or more features of another of the examples, or a combination of other examples. Furthermore, equivalents and modifications not described above may also be employed without departing from the scope of the invention, which is defined in the accompanying claims. In the claims, the word "comprising" does not exclude other elements or operations, and the indefinite article "a" or "an" does not exclude a plurality. The mere fact that certain features are recited in mutually different dependent claims does not indicate that a combination of these features cannot be used to advantage. Any reference signs in the claims should not be construed as limiting their scope.

## Claims

1. A cooling fluid deflector (100, 200, 300) for a server (102) comprising a first processor (104) and a second processor (106) wherein the first and second processors are arranged on a plane (108) defined by a support layer of the first processor and/or the second processor and sequentially with respect to a server cooling fluid inflow direction (110);
wherein at least a portion of the cooling fluid deflector (100, 200, 300) is configured to be disposed between the first processor (104) and the second processor (106);
wherein the cooling fluid deflector (100, 200, 300) is configured to re-direct a first portion (112) of a cooling fluid inflow (114) that has entered the server (102) along the server cooling fluid inflow direction (110) and has cooled the first processor (104), laterally with respect to the server cooling fluid inflow direction and across the plane (108) such that at least a portion of the re-directed first portion of the cooling fluid inflow bypasses the second processor (106) by passing laterally with respect to the second processor; and
wherein the cooling fluid deflector (100, 200, 300) is configured to re-direct a second portion (116) of the cooling fluid inflow (114) that has bypassed the first processor (104), laterally with respect to the server cooling fluid inflow direction (110) and across the plane (108) such that at least a portion of the re-directed second portion of the cooling fluid inflow flowing laterally across the plane (108) cools the second processor (106).

2. The cooling fluid deflector (100, 300) according to claim 1, wherein the cooling fluid deflector comprises a plurality of foils (118), including at least a first foil (118^{A}_{1..i}), and at least a second foil (118^{B}_{1..j}); and
wherein the at least a first foil (118^{A}_{1..i}) is configured to cause the re-directing of the first portion (112) of the cooling fluid inflow (114) that has cooled the first processor (104), laterally with respect to the server cooling fluid inflow direction and across the plane (108); and
wherein the at least a second foil (118^{B}_{1..j}) is configured to cause the re-directing of the second portion (116) of the cooling fluid inflow (114) that has bypassed the first processor (104), laterally with respect to the server cooling fluid inflow direction (110) and across the plane (108).

3. The cooling fluid deflector (100, 300) according to claim 1 or claim 2, wherein the cooling fluid deflector comprises a plurality of foils (118), and wherein the foils define one or more channels (120), including:
a first set of one or more channels (120₄, 120_{4,5}) configured to feed a portion of the first portion (112) of the cooling fluid inflow that has cooled the first processor (104), onto the second processor (106) and/or laterally with respect to the second processor (106) such that it bypasses the second processor;
wherein the first set of one or more channels (120₄, 120_{4,5}) have a combined fluid inlet cross sectional area (D₁, D'₁), and a combined fluid outlet cross sectional area (D₂, D'₂), and wherein the combined fluid inlet cross sectional area (D₁, D'₁) of the first set of one or more channels (120₄, 120_{4,5}) is smaller than the combined fluid outlet cross sectional area (D₂, D'₂) of the first set of one or more channels (120₄, 120_{4,5}).

4. The cooling fluid deflector (100, 300) according to any one of claims 1 - 3, wherein the cooling fluid deflector comprises a plurality of foils (118), and wherein the foils define one or more channels (120), including:
a second set of one or more channels (120₃, 120_{1..3}) configured to feed a portion of the first portion (112) of the cooling fluid inflow that has cooled the first processor (104) and/or a portion of the second portion (116) of the cooling fluid inflow that has bypassed the first processor (104), onto the second processor (106);
wherein the second set of one or more channels (120₃, 120_{1..3}) have a combined fluid inlet cross sectional area (D₃, D'₃) and a combined fluid outlet cross sectional area (D₄, D'₄), and wherein the combined fluid outlet cross sectional area (D₄, D'₄) of the second set of one or more channels (120₃, 120_{1..3}) is smaller than the combined fluid inlet cross sectional area (D₃, D'₃) of the second set of one or more channels (120₃, 120_{1..3}).

5. The cooling fluid deflector (200) according to claim 1, wherein the cooling fluid deflector is provided by a fluid-moving device (122);
wherein the fluid-moving device (122) is configured to generate a fluid stream (124) laterally with respect to the server cooling fluid inflow direction (110) and across the plane (108); and
wherein the fluid stream (124) laterally with respect to the server cooling fluid inflow direction (110) and across the plane (108) is configured to cause the re-directing of the first and second portions (112, 116) of the cooling fluid inflow laterally with respect to the server cooling fluid inflow direction (110) and across the plane (108).

6. The cooling fluid deflector (300) according to claim 1, wherein the cooling fluid deflector is provided by one or more heatsinks (126, 136', 138');
wherein the one or more heatsinks (126, 136', 138') comprise a plurality of heatsink elements (128); and
wherein a first group (128^{A}_{1..p}) of the heatsink elements are configured to cause the re-directing of the first portion (112) of the cooling fluid inflow (114) that has cooled the first processor (104), laterally with respect to the server cooling fluid inflow direction (110) and across the plane (108); and
wherein a second group (128^{B}_{1..q}) of the heatsink elements are configured to cause the re-directing of the second portion (116) of the cooling fluid inflow (114) that has bypassed the first processor (104), laterally with respect to the server cooling fluid inflow direction (110) and across the plane (108).

7. The cooling fluid deflector (100, 200, 300) according to any previous claim, wherein the cooling fluid deflector is configured to cause the re-directing of the first portion (112) of the cooling fluid inflow such that at least a portion of the re-directed first portion of the cooling fluid inflow flowing laterally across the plane (108) cools the second processor (106).

8. The cooling fluid deflector (100, 300) according to any one of claims 2 - 4, wherein the first processor (104) and the second processor (106) each comprise one or more memory boards (130, 130'), or one or more memory blanking boards, and wherein the one or more boards (130, 130') are arranged laterally with respect to the corresponding processor (104, 106) such that the one or more boards extend along the server cooling fluid inflow direction (110) and outwards with respect to the plane (108), and wherein:
the one or more boards (130) of the first processor (104) are separated from the first processor (104) to provide at least one memory board channel (132) for guiding the second portion (116) of the cooling fluid inflow such that it bypasses the first processor (104); and
wherein at least one of the at least a second foil (118^{B}₁) of the cooling fluid deflector is configured to adjoin at least one of one or more corresponding boards (130'₄) of the second processor (106) for guiding the second portion (116) of the cooling fluid inflow that has bypassed the first processor (104) between the at least a second foil (118^{B}₁) and the one or more corresponding boards (130'₄) of the second processor (106);
and/or
the one or more boards (130') of the second processor (106) are separated from the second processor to provide at least one memory board channel (134) for guiding the at least a portion of the re-directed first portion (112) of the cooling fluid inflow that bypasses the second processor (106) past the second processor (106); and
wherein at least one of the at least a first foil (118^{A}₁) of the cooling fluid deflector (100, 300) is configured to adjoin at least one of one or more corresponding boards (130₄) of the first processor (104) for guiding the at least a portion of the re-directed first portion (112) of the cooling fluid inflow between the one or more boards (130₄) of the first processor (104) and the at least a first foil (118^{A}₁).

9. The cooling fluid deflector according to any one of claims 1 - 8, wherein the first and second processors (104, 106) are thermally coupled to respective first and second heatsinks (136, 138), or wherein the first and second processors are thermally coupled to a common heatsink (140); and
wherein the first portion (112) of the cooling fluid inflow passes through the first heatsink (136), or through a first portion of the common heatsink (140), respectively, for cooling the first processor (104); and
wherein the at least a portion of the re-directed second portion (116) of the cooling fluid inflow passes through the second heatsink (138), or through a second portion of the common heatsink (140), respectively, for cooling the second processor (106).

10. A kit of cooling fluid deflectors (100, 200, 300, 400, 500) for a server (102) comprising a housing (144) and a first processor (104) and a second processor (106) wherein the first and second processors are arranged within the housing (144) on a plane (108) defined by a support layer of the first processor and/or the second processor and sequentially with respect to a server cooling fluid inflow direction (110) and wherein the processors are arranged within the housing to provide a gap (146_{1,2}, 146'_{1,2}) between each processor and each of two opposing inner surfaces (148₁, 148₂) of the housing, the gaps being disposed laterally with respect to the corresponding processor (104, 106), the kit comprising:
the cooling fluid deflector (100, 200, 300) according to claim 1; and
a second cooling fluid deflector (400) and/or a third cooling fluid deflector (500);
wherein at least a portion of the second cooling fluid deflector (400) is configured to be disposed upstream of the first processor (104) with respect to the server cooling fluid inflow direction (110), and laterally with respect to the first processor, and wherein the second cooling fluid deflector (400) is configured to re-direct a portion of the cooling fluid inflow (114) that has entered the server (102) along the server cooling fluid inflow direction (110), from the gap (146₁) between the first processor (104) and a first inner surface (148₁) of the housing, laterally with respect to the server cooling fluid inflow direction and across the plane (108) such that at least a portion of the cooling fluid inflow (114) that has entered the server (102) is prevented from entering the gap (146₁) between the first processor (104) and the first inner surface (148₁) of the housing and instead cools the first processor (104) and/or increases a flow rate of the second portion (116) of the cooling fluid inflow (114) that bypasses the first processor (104); and
wherein at least a portion of the third cooling fluid deflector (500) is configured to be disposed downstream of the second processor (106) with respect to the server cooling fluid inflow direction (110), and laterally with respect to the second processor (106), and wherein the third cooling fluid deflector (500) is configured to guide at least a portion of the re-directed second portion (116) of the cooling fluid inflow that has cooled the second processor (106) towards a second inner surface (148₂) of the housing for smoothing a transition of the at least a portion of the re-directed second portion (116) of the cooling fluid inflow that has cooled the second processor (106) between the second processor and the second inner surface (148₂) of the housing.

11. The kit of cooling fluid deflectors (100, 200, 300, 400, 500) according to claim 10, wherein the third cooling fluid deflector (500) comprises one or more foils (518), and wherein the one or more foils (518) define at least one channel (520) for guiding the at least a portion of the re-directed second portion (116) of the cooling fluid inflow (114) that has cooled the second processor (106) towards the second inner surface (148₂) of the housing.

12. A baffle for a server (102) comprising a housing (144) and a first processor (104) and a second processor (106) wherein the first and second processors are arranged within the housing on a plane (108) defined by a support layer of the first processor and/or the second processor and sequentially with respect to a server cooling fluid inflow direction (110) and wherein the processors are arranged within the housing to provide a gap (146_{1,2}, 146'_{1,2}) between each processor and each of two opposing inner surfaces (148₁, 148₂) of the housing, the gaps being disposed laterally with respect to the corresponding processor, the baffle comprising:
a support; and
the cooling fluid deflector (100, 200, 300) according to any one of claims 1 - 9; and
a second cooling fluid deflector (400) and/or a third cooling fluid deflector (500);
wherein the cooling fluid deflector (100, 200, 300) and the second cooling fluid deflector (400) and/or the third cooling fluid deflector (500), are coupled to the support; and
wherein at least a portion of the second cooling fluid deflector (400) is configured to be disposed upstream of the first processor (104) with respect to the server cooling fluid inflow direction (110), and laterally with respect to the first processor, and wherein the second cooling fluid deflector (400) is configured to re-direct a portion of the cooling fluid inflow (114) that has entered the server (102) along the server cooling fluid inflow direction (110) via a fluid inlet (154) in the housing (144), from the gap (146₁) between the first processor (104) and a first inner surface (148₁) of the housing, laterally with respect to the server cooling fluid inflow direction and across the plane (108) such that at least a portion of the cooling fluid inflow (114) that has entered the server (102) is prevented from entering the gap (146₁) between the first processor (104) and the first inner surface (148₁) of the housing and instead cools the first processor (104) and/or increases a flow rate of the second portion (116) of the cooling fluid inflow (114) that bypasses the first processor (104); and
wherein at least a portion of the third cooling fluid deflector (500) is configured to be disposed downstream of the second processor (106) with respect to the server cooling fluid inflow direction (110), and laterally with respect to the second processor, and wherein the third cooling fluid deflector (500) is configured to guide at least a portion of the re-directed second portion of the cooling fluid inflow that has cooled the second processor (106) towards a second inner surface (148₂) of the housing for smoothing a transition of the at least a portion of the re-directed second portion of the cooling fluid inflow that has cooled the second processor (106) between the second processor and the second inner surface (148₂) of the housing.

13. A cover (142) for a server (102) comprising a housing (144) and a first processor (104) and a second processor (106) wherein the first and second processors are arranged within the housing on a plane (108) defined by a support layer of the first processor and/or the second processor and sequentially with respect to a server cooling fluid inflow direction (110) and wherein the processors are arranged within the housing to provide a gap (146_{1,2}, 146'_{1,2}) between each processor and each of two opposing inner surfaces (148₁, 148₂) of the housing, the gaps being disposed laterally with respect to the corresponding processor, wherein the cover (142) comprises the kit of cooling fluid deflectors (100, 200, 300, 400, 500) according to claim 10; and
wherein the cooling fluid deflector (100, 200, 300) and the second cooling fluid deflector (400) and/or the third cooling fluid deflector (500) are coupled to the cover (142) and arranged such that when the cover is coupled to the server (102):
at least a portion of the cooling fluid deflector (100, 200, 300) is disposed between the first processor (104) and the second processor (106); and
at least a portion of the second cooling fluid deflector (400) is disposed upstream of the first processor (104) with respect to the server cooling fluid inflow direction (110), and laterally with respect to the first processor; and
at least a portion of the third cooling fluid deflector (500) is disposed downstream of the second processor (106) with respect to the server cooling fluid inflow direction (110), and laterally with respect to the second processor.

14. A server (102) comprising:
the cooling fluid deflector (100, 200, 300) according to any one of claims 1 - 9;
or
the kit of cooling fluid deflectors (100, 200, 300, 400, 500) according to any one of claims 10 - 11;
or
the baffle according to claim 12;
or
the cover (142) according to claim 13.

15. A cooling fluid deflector (100, 300) for a server (102) comprising a first processor (104) and a second processor (106), wherein the cooling fluid deflector comprises a plurality of foils (118), and wherein the foils define one or more channels (120), including:
a first set of one or more channels (120₄, 120_{4,5}) configured to feed a portion of a cooling fluid inflow (112) that has cooled the first processor (104), onto the second processor (106) and/or laterally with respect to the second processor (106) such that it bypasses the second processor;
a second set of one or more channels (120₃, 120_{1..3}) configured to feed a portion of the cooling fluid inflow (112) that has cooled the first processor (104) and/or a portion of a second portion (116) of a cooling fluid inflow that has bypassed the first processor (104), onto the second processor (106);
wherein the first set of one or more channels (120₄, 120_{4,5}) have a combined fluid inlet cross sectional area (D₁, D'₁), and a combined fluid outlet cross sectional area (D₂, D'₂), and wherein the combined fluid inlet cross sectional area (D₁, D'₁) of the first set of one or more channels (120₄, 120_{4,5}) is smaller than the combined fluid outlet cross sectional area (D₂, D'₂) of the first set of one or more channels (120₄, 120_{4,5});
and/or
wherein the second set of one or more channels (120₃, 120_{1..3}) have a combined fluid inlet cross sectional area (D₃, D'₃) and a combined fluid outlet cross sectional area (D₄, D'₄), and wherein the combined fluid outlet cross sectional area (D₄, D'₄) of the second set of one or more channels (120₃, 120_{1..3}) is smaller than the combined fluid inlet cross sectional area (D₃, D'₃) of the second set of one or more channels (120₃, 120_{1..3}).
